(19) Europäisches Patentamt
European Patent Office
Office européen des brevets

(11) EP 4 742 869 A1

(12) **EUROPEAN PATENT APPLICATION**

(43) Date of publication:
**13.05.2026 Bulletin 2026/20**

(21) Application number: **25214205.4**

(22) Date of filing: **07.11.2025**

(51) International Patent Classification (IPC):
***H10K 59/121** (2023.01)* ***H10K 59/80** (2023.01)*

(52) Cooperative Patent Classification (CPC):
**H10K 59/879; H10K 59/121;** H10K 59/876

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **12.11.2024 JP 2024197522**
**19.08.2025 JP 2025136341**

(71) Applicant: **Canon Kabushiki Kaisha**
**Tokyo, 146-8501 (JP)**

(72) Inventors:
- **TAKAHASHI, Tetsuo**
  **Tokyo (JP)**
- **SANO, Hiroaki**
  **Tokyo (JP)**
- **HINATA, Shoma**
  **Tokyo (JP)**
- **SATO, Ryo**
  **Tokyo (JP)**
- **ITO, Takayuki**
  **Tokyo (JP)**
- **MATSUDA, Yojiro**
  **Tokyo (JP)**

(74) Representative: **WESER & Kollegen Patentanwälte PartmbB**
**Radeckestraße 43**
**81245 München (DE)**

(54) **LIGHT EMITTING DEVICE, DISPLAY DEVICE, PHOTOELECTRIC CONVERSION DEVICE, ELECTRONIC APPARATUS, ILLUMINATION DEVICE, MOVING BODY, AND WEARABLE DEVICE**

(57) A light emitting device including first and second pixels is provided. Each of the first and second pixels includes a microlens and a light emitting element including a light emitting layer arranged between a main surface of a substrate and the microlens. A luminance distribution in a light emitting region of the light emitting layer of the first pixel and a luminance distribution in a light emitting region of the light emitting layer of the second pixel are different from each other The microlens is arranged at a position where, in a case where light enters toward the light emitting layer while passing through the microlens from a normal direction of the main surface, an area of a region where a light beam having passed through the entire microlens enters becomes larger than an area of the light emitting region.

F I G. 7A F I G. 7B

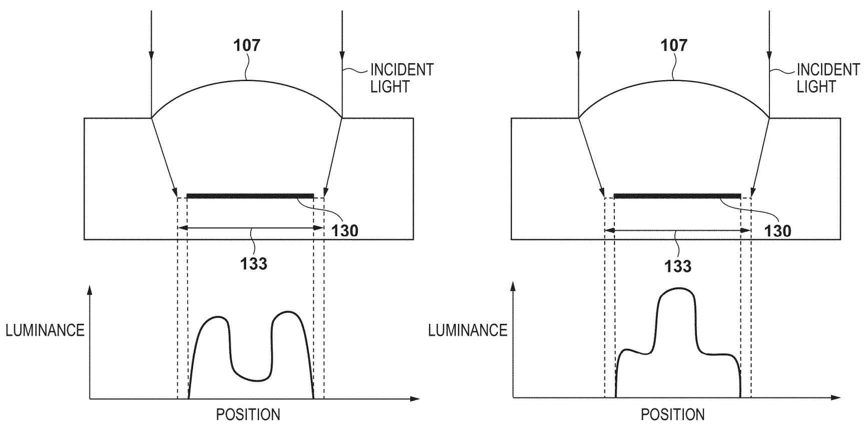




Processed by Luminess, 75001 PARIS (FR)

## Description

TECHNICAL FIELD

The aspect of the embodiments relates to a light emitting device, a display device, a photoelectric conversion device, an electronic apparatus, an illumination device, a moving body, and a wearable device.

BACKGROUND

A light emitting device including a light emitting element such as an organic electroluminescence (EL) element is known. Japanese Patent Laid-Open No. 2022-080507 describes an electrooptical device that includes a microlens on a light emitting element to improve light extraction efficiency.

SUMMARY

If the luminance distribution in the light emitting region of the light emitting element varies among the light emitting elements, the intensity of light extracted by the microlens can vary among the light emitting elements due to the variation of the luminance distribution.

The present disclosure in its first aspect provides a light emitting device as specified in claim 1. Optional features are specified in claims 2 to 14.

The present disclosure in its second aspect provides a display device as specified in claim 15.

The present disclosure in its third aspect provides a photoelectric conversion device as specified in claim 16.

The present disclosure in its fourth aspect provides an electronic apparatus as specified in claim 17.

The present disclosure in its fifth aspect provides an illumination device as specified in claim 18.

The present disclosure in its sixth aspect provides a moving body as specified in claim 19.

The present disclosure in its seventh aspect provides a wearable device as specified in claim 20.

Features of the disclosure will become apparent from the following description of embodiments with reference to the attached drawings. The following description of embodiments is described by way of example.

BRIEF DESCRIPTION OF THE DRAWINGS

Fig. 1 is a sectional view showing an example of the configuration of a light emitting device according to an embodiment;
Fig. 2 is a view for explaining light emitted from a pixel of the light emitting device shown in Fig. 1;
Fig. 3 is a view for explaining light entering the pixel of the light emitting device shown in Fig. 1;
Fig. 4 is a view showing an example of the optical path of light passing through a microlens of the light emitting device shown in Fig. 1;
Fig. 5 is a view showing an example of the optical path of light passing through a microlens of the light emitting device shown in Fig. 1;
Figs. 6A and 6B are views for explaining the light emitting device of a comparative example;
Figs. 7A and 7B are views for explaining the effect of the light emitting device shown in Fig. 1;
Fig. 8 is a view for explaining evaluation of the distribution of light emission intensity of the light emitting device shown in Fig. 1;
Fig. 9 is a view showing an example of the optical path of light passing through a microlens of the light emitting device shown in Fig. 1;
Figs. 10A and 10B are an orthogonal projection view and a sectional view showing a modification of the light emitting device shown in Fig. 1;
Fig. 11 is a sectional view showing a modification of the light emitting device shown in Fig. 1;
Figs. 12A and 12B are sectional views showing an example of the configuration of a pixel of the light emitting device according to the embodiment;
Figs. 13A to 13C are views showing an example of an image forming apparatus using the light emitting device according to the embodiment;
Fig. 14 is a view showing an example of a display device using the light emitting device according to the embodiment;
Fig. 15 is a view showing an example of a photoelectric conversion device using the light emitting device according to the embodiment;
Fig. 16 is a view showing an example of an electronic apparatus using the light emitting device according to the

embodiment;

Figs. 17A and 17B are views each showing an example of a display device using the light emitting device according to the embodiment;

Fig. 18 is a view showing an example of an illumination device using the light emitting device according to the embodiment;

Figs. 19A and 19B are views showing an example of a moving body using the light emitting device according to the embodiment; and

Figs. 20A and 20B are views each showing an example of a wearable device using the light emitting device according to the embodiment.

DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

With reference to Figs. 1 to 11, a light emitting device according to an embodiment of the disclosure will be described. Fig. 1 is a sectional view showing an example of the configuration of a light emitting device 100 according to this embodiment. The light emitting device 100 includes a plurality of pixels 110. Fig. 1 shows two pixels 110, but more pixels 110 may be arranged in practice. For example, the pixels 110 may be arranged in a matrix. The pixels 110 are formed on a substrate 101.

The pixel 110 includes a microlens 107 arranged above a main surface 109 of the substrate 101, and a light emitting element 120 arranged between the main surface 109 of the substrate 101 and the microlens 107. The light emitting element 120 can include a lower electrode 102 arranged between the main surface 109 of the substrate 101 and the microlens 107, an upper electrode 104 arranged between the lower electrode 102 and the microlens 107, and an organic compound layer 103 including a light emitting layer 131 arranged between the lower electrode 102 and the upper electrode 104.

The light emitting device 100 can further include a structure 108 arranged between the substrate 101 and the lower electrode 102. A wiring pattern for electrically connecting an element such as a transistor arranged in the substrate 101 and the lower electrode 102, and the like can be arranged in the structure 108. In the configuration shown in Fig. 1, the lower electrode 102 is divided and arranged for each pixel 110 (light emitting element 120), and the light emitting device 100 further includes an insulating layer 105 including opening portions 132 for exposing a part of each lower electrode 102 to the organic compound layer 103. In the configuration shown in Fig. 1, the upper electrode 104 is shared by a plurality of pixels 110 (light emitting elements 120), and the light emitting device 100 further includes a protective layer 106 arranged between the upper electrode 104 and the microlenses 107.

The light emitting layer 131 emits light according to the potential difference applied between the lower electrode 102 and the upper electrode 104. The lower electrode 102 and the organic compound layer 103 are in contact with each other in the opening portion 132 provided in the insulating layer 105. A portion of the light emitting layer 131 arranged in the organic compound layer 103, which corresponds to the opening portion 132 of the insulating layer 105, is a light emitting region 130 where light is emitted. It can also be said that the position of the opening portion 132 of the insulating layer 105 matches the position of the light emitting region 130 of the light emitting layer 131, where light is emitted, in an orthogonal projection to the main surface 109 of the substrate 101. In each pixel 110, the microlens 107 may have a curved surface portion corresponding to the light emitting region 130 of the light emitting element 120, and is provided on the protective layer 106.

The substrate 101 is not particularly limited as long as it can support the elements constituting the above-described light emitting device 100. For example, glass, plastic, silicon, or the like can be used as the material of the substrate 101. A switching element such as a transistor, a wiring pattern, and an interlayer insulating film can be arranged in the substrate 101 and on the substrate 101 (in the structure 108).

The lower electrode 102 may be transparent or opaque for light emitted from the light emitting layer 131. If the lower electrode 102 is a reflective layer (opaque), a material such as a metal having a reflectance of 70% or more at the emission wavelength of the light emitting layer 131 may be used as the lower electrode 102. Here, the emission wavelength means the spectrum range of light emitted from the light emitting layer 131. For example, as the material of the lower electrode 102, a metal such as aluminum or silver, or an alloy thereof added with silicon, copper, nickel, neodymium, or the like can be used. As long as the reflectance of the lower electrode 102 is higher than a predetermined (desired) reflectance, the lower electrode 102 may have a layered structure with a barrier electrode using a metal such as titanium, tungsten, molybdenum, or gold, or an alloy thereof, in addition to the above-described material. Alternatively, for example, the lower electrode 102 may have a layered structure with a transparent conductive oxide such as ITO, IZO, AZO, or IGZO.

On the other hand, if the lower electrode 102 is not used as a reflective layer, a transparent conductive oxide may be used as the material of the lower electrode 102. Examples of the transparent conductive oxide are ITO, IZO, AZO, IGZO, or the like. If the lower electrode 102 is transparent, a reflective layer may be provided below (the substrate 101 side) the lower electrode 102. To obtain a predetermined optical distance, a configuration where an insulating film is provided between the transparent lower electrode 102 and the reflective layer may be employed. The film thickness of the transparent lower electrode 102 or the film thickness of the insulating film arranged between the lower electrode 102 and the reflective layer can be set in accordance with the color emitted by each pixel 110 (light emitting element 120).

The upper electrode 104 is translucent. The material of the upper electrode 104 may be a semi-transmissive material having a property of transmitting part of light that has reached the surface of the upper electrode 104 and reflecting the remaining part of the light (that is, a semi-transmissive reflective property). As the material of the upper electrode 104, for example, a transparent material such as the above-described transparent conductive oxide may be used. As the material of the upper electrode 104, a semi-transmissive material such as aluminum, silver, gold, an alkali metal (lithium, cesium, or the like), an alkali earth metal (magnesium, calcium, barium, or the like), or an alloy material containing these metal materials may be used.

If a semi-transmissive material is used as the material of the upper electrode 104, an alloy containing magnesium or silver as a main component may be used. As long as the upper electrode 104 has an appropriate transmittance, the upper electrode 104 may have a layered structure including a plurality of layers made of the above-described materials or the like. In the configuration shown in Fig. 1, one upper electrode 104 is shared by the plurality of light emitting elements 120, but a plurality of upper electrodes 104 respectively corresponding to the plurality of light emitting elements 120 may be provided.

One of the lower electrode 102 and the upper electrode 104 functions as an anode, and the other functions as a cathode. For example, the lower electrode 102 may function as an anode and the upper electrode 104 may function as a cathode. Alternatively, the lower electrode 102 may function as a cathode and the upper electrode 104 may function as an anode.

Each of the lower electrode 102, the upper electrode 104, and the organic compound layer 103 can be formed using a known technique such as a sputtering method, a deposition method, or a spin coating method. Each of the lower electrode 102 and the upper electrode 104 may be formed from a plurality of layers. The organic compound layer 103 may include at least one of a hole injection layer, a hole transport layer, an electron blocking layer, a hole blocking layer, an electron transport layer, and an electron injection layer, in addition to the light emitting layer 131.

Light is emitted when holes injected from the anode and electrons injected from the cathode are recombined in the light emitting layer 131. The light emitting layer 131 may be formed from a single layer or a plurality of layers. When a light emitting layer made of a red light emitting material, a light emitting layer made of a green light emitting material, and a light emitting layer made of a blue light emitting material are combined, light beams (red light, green light, and blue light) from the respective light emitting layers can be mixed to obtain white light. Two kinds of light emitting layers whose light emission colors have a complimentary color relationship (for example, a light emitting layer made of a blue light emitting material and a light emitting layer made of a yellow light emitting material) may be combined. A material contained in the light emitting layer 131 and the configuration of the light emitting layer 131 may be different for each pixel 110 (light emitting element 120) so that the light emitting layer 131 emits light of a different color for each pixel 110 (light emitting element 120). In this case, the light emitting layer 131 may be patterned for each pixel 110 (light emitting element 120).

The light emitting device 100 according to this embodiment may include a first reflective surface, a second reflective surface, and the light emitting layer 131 arranged between the first reflective surface and the second reflective surface. The first reflective surface may be the lower electrode 102, a reflective layer arranged between the substrate 101 and the transparent lower electrode 102, or a reflective layer arranged between the lower electrode 102 and the light emitting layer 131. The second reflective surface may be the upper electrode 104, or a semi-transmissive reflective layer arranged between the upper electrode 104 and the microlens.

The protective layer 106 can be a dielectric layer that is translucent and contains an inorganic material having a low permeability for oxygen and water from the outside of the light emitting device 100 to the light emitting element 120. For example, the protective layer 106 may be formed using an inorganic material such as a silicon oxide-based material like silicon nitride, silicon oxynitride, or silicon oxide. Also, for example, the protective layer 106 may be formed using an inorganic material such as aluminum oxide, or titanium oxide. In terms of the protection performance, an inorganic material such as silicon nitride, silicon oxynitride, or aluminum oxide may be used. A chemical vapor deposition (CVD) method, an atomic layer deposition (ALD) method, a sputtering method, or the like can be used to form the protective layer 106.

The protective layer 106 can have a single-layer structure or a layered structure using the above-described materials and forming methods in combination as long as the protective layer 106 has sufficient moisture barrier property. For example, the protective layer 106 may have a layered structure of a layer of silicon nitride formed using the CVD method and another material layer having a high density formed using the ALD method. Furthermore, the protective layer 106 may include an organic layer of a resin or the like as long as it has appropriate moisture barrier property. For example, polyacrylate, polyamide, polyester, epoxy, or the like may be used for the protective layer 106. Furthermore, in the

configuration shown in Fig. 1, one protective layer 106 is shared by the plurality of light emitting elements 120, but a plurality of protective layers 106 respectively corresponding to the plurality of light emitting elements 120 may be provided.

The microlens 107 can be formed using an exposure process and a developing process. More specifically, a material film (photoresist film) of the microlens 107 is formed, and the photoresist film is exposed and developed using a mask including a continuous gradation change. As the mask, a gray mask can be used. As the mask, an area gradation mask that allows light irradiation with a continuous gradation change on the imaging plane by changing the density distribution of dots of a light shielding film with a resolution equal to or lower than the resolution of an exposure device can also be used.

The lens shape can be adjusted by etching back the microlens 107 formed using the exposure process and the developing process. In one embodiment, the microlens 107 need only have a curved surface that has power of condensing light from the light emitting region 130. The curved surface may be a part of a spherical surface, or may be an aspherical surface. More specifically, in a case where, as in this embodiment, the curved surface portion of the microlens 107 protrudes toward the light-extraction side, and light is extracted in a layer such as air (for example, an air layer) having a refractive index lower than that of the microlens 107, the curved surface portion need only be a curved surface that is convex upward.

In the example shown in Fig. 1, a layer contacting the microlens 107 on the light-extraction side is air. However, a refractive index $n_0$ of the layer need only be lower than a refractive index $n_1$ of the microlens 107. For example, a transparent resin may be arranged on the microlens 107.

In the configuration shown in Fig. 1, the microlenses 107 are provided directly on the protective layer 106. However, the configuration is not limited to this, and a planarizing layer may be provided between the protective layer 106 and the microlenses 107 for the purpose of planarizing the unevenness of the upper surface of the protective layer 106. A color filter or a light absorbing layer may be provided for the purpose of improving color purity or the view angle characteristic. The color filter or the light absorbing layer may be arranged between the protective layer 106 and the microlens 107, or may be arranged on the microlens 107. Alternatively, for example, a color filter and the protective layer 106 may be integrated, or the microlens 107 and a color filter may be integrated. Furthermore, for example, a color filter may be formed on a substrate different from the substrate 101, and the substrates may be bonded so that the color filter faces the protective layer 106. Alternatively, the protective layer 106 and the microlens 107 may be integrally formed. When the protective layer 106 and the microlens 107 is formed integrally, the curved surface portion of the microlens 107 can be formed while being accurately aligned with the light emitting region 130. In addition, the distance between the microlens 107 and the light emitting region 130 can be made small, thereby improving the view angle characteristic.

As described above, the pixel 110 includes the light emitting element 120 and the microlens 107, and the light emitting element 120 includes the light emitting layer 131 (light emitting region 130) arranged between the main surface 109 of the substrate 101 and the microlens 107. The microlens 107 has a curved surface portion protruding in a direction away from the main surface 109 of the substrate 101, that is, the light-emission side. The light emitting region 130 is an upper surface portion of the light emitting layer 131 corresponding to the upper portion of the opening portion 132 of the insulating layer 105. Hereinafter, a direction perpendicular to the main surface 109 of the substrate 101 is described as a "normal direction" and a direction parallel to the substrate is described as a "horizontal direction".

Here, when the normal direction is defined as 0° with respect to the main surface 109 of the substrate 101, a light ray which is in the opposite direction to the light ray emitted from the light emitting region 130 through the microlens 107 at an arbitrary angle is referred to as "incident light". The optical path of the incident light traces the emitted light in the opposite direction. When light parallel to the normal direction to the main surface 109 of the substrate 101 passes through the microlens 107 and enters toward the light emitting layer 131, a light beam having passed through the entire microlens 107 is condensed due to the power of the microlens 107. The region where this light beam enters a plane including the upper surface of the light emitting layer 131 (light emitting region 130) is referred to as an "incident region" 133. The incident light and the incident region 133 will be described with reference to Figs. 2 and 3.

Fig. 2 shows a sectional view perpendicular to the main surface 109 of the substrate 101 and passing through the vertex in the curved surface portion of the microlens 107. Fig. 2 shows a state in which, among light rays emitted from the light emitting region 130, passing through the microlens 107, and extracted in the normal direction perpendicular to the main surface 109 of the substrate 101, the light ray extracted from the end portion of the light emitting region 130 is emitted in the normal direction. To the contrary to the direction of light shown in Fig. 2, Fig. 3 shows the incident light that enters while tracing, in the opposite direction, the light ray emitted from the light emitting region 130 shown Fig. 2. Fig. 3 shows only the incident light passing through the end portion of the microlens 107. However, as described above, the incident region 133 is the region where the light beam having passed through the entire microlens 107 from the normal direction enters the plane including the upper surface of the light emitting layer 131 (light emitting region 130). For the sake of descriptive simplicity, Figs. 2 and 3 show only the light emitting region 130 and the microlens 107. This also applies to Figs. 4 to 7.

Next, with reference to Figs. 4 and 5, the relationship between the light emitting region 130 and the incident region 133 will be described. Fig. 4 shows a case where the whole outer edge of the incident region 133 is inside the outer edge of

the light emitting region 130 in a plane view, and the area of the incident region 133 is smaller than the area of the light emitting region 130. The incident light passing through the end portion of the microlens 107 enters inside the end portion of the light emitting region 130 in the plane including the upper surface of the light emitting layer 131 (light emitting region 130). Therefore, the light emitted from the end portion of the light emitting region 130 and passing through the end portion of the microlens 107, which is nearest to the end portion of the light emitting region 130, is refracted due to the power of the microlens 107 and emitted in a direction in which light is condensed.

On the other hand, Fig. 5 shows a case where the whole outer edge of the light emitting region 130 is inside the outer edge of the incident region 133 in a plane view, and the area of the incident region 133 is larger than the area of the light emitting region 130. Here, when light passes through the microlens 107 from the normal direction to the main surface 109 of the substrate 101 and enters toward the light emitting layer 131, the area of the incident region 133 where the light beam having passed through the entire microlens 107 enters is defined as S1. The area of the light emitting region 130 is defined as S2. In this case, in each pixel 110, the microlens 107 is arranged at a position where the area S1 of the incident region 133 is larger than the area S2 of the light emitting region 130. Here, the incident region 133 indicates the region where light enters a plane including the upper surface of the light emitting layer 131 and parallel to the main surface 109 of the substrate 101. Hence, the incident light passing through the end portion of the microlens 107 enters outside the end portion of the light emitting region 130 in the plane including the upper surface of the light emitting layer 131 (light emitting region 130). Therefore, the light emitted from the end portion of the light emitting region 130 and passing through the end portion of the microlens 107, which is nearest to the end portion of the light emitting region 130, is refracted due to the power of the microlens 107 and emitted as diverging light. Diverging light is light which is not condensed on the microlens 107 after being emitted from the microlens 107, as shown in Fig. 5, and travels toward outside a region obtained by projecting the microlens 107 in the normal direction to the main surface 109 of the substrate 101.

Next, with reference to Fig. 9, the area of the incident region 133 and the area of the light emitting region 130 will be described in detail. The upper surface of the microlens 107 has a convex curved surface 201 in a direction away from the main surface 109 of the substrate 101. A vertex 202 of the curved surface 201 is a portion of the curved surface 201 forming the upper surface of the microlens 107 that is furthest from the main surface 109 of the substrate 101. An end portion 203 of the curved surface 201 can be a set of points where an inclination angle $\theta$ is maximum on the curved surface 201. For example, even if the curved surface 201 extends in the right direction from the end portion 203 at an angle smaller than the inclination angle $\theta$ at the end portion 203, this is not considered as the effective lens curved surface of the light emitting element 120. This is because this lens curved surface does not provide the ideal lens light-condensing effect. Fig. 9 shows a section in the normal direction to the main surface 109 of the substrate 101, which passes through the vertex 202 of the curved surface 201 forming the upper surface of the microlens 107.

As shown in Fig. 9, the difference in height between the vertex 202 and the end portion 203 in the normal direction to the main surface 109 of the substrate 101 is defined as h [μm] (to be sometimes referred to as the "distance h" hereinafter). The distance between the vertex 202 and the end portion 203 in an orthogonal projection to the main surface of the substrate 101 is defined as r [μm] (to be sometimes referred to as the "distance r" hereinafter). The difference in height between the end portion 203 and the light emitting region 130 in the normal direction to the main surface 109 of the substrate 101 is defined as H [μm] (to be sometimes referred to as the "distance H" hereinafter). The distance from the center of the light emitting region 130 to the end portion of the light emitting region 130 is defined as a [μm] (to be sometimes referred to as the "distance a" hereinafter).

At the end portion 203 of the curved surface 201, the inclination angle $\theta$ of the microlens 107 is maximum on the curved surface 201. If the curved surface 201 is a spheric surface, the inclination angle $\theta$ at the end portion 203 is given by $\sin\theta = 2rh/(r^2 + h^2)$ using the distance h and the distance r. Consider a light ray which is refracted at a point on the curved surface 201 with the inclination angle $\theta$, and extracted in the normal direction to the main surface 109 of the substrate 101. An incident angle $\alpha$ to the curved surface 201 is given by $n_1 \cdot \sin\alpha = n_0 \cdot \sin\theta$ according to Snell's law, using a refractive index $n_0$ of the layer on the light-extraction side at the curved surface 201 and a refractive index $n_1$ of the layer (the microlens 107 in this configuration example) on the light emitting region 130 side at the curved surface 201. An angle $\beta 1$ of the light ray with respect to the normal direction inside the layer (the microlens 107 in this configuration example) on the light emitting region 130 side at the curved surface 201 is given by $\beta 1 = |\theta - \alpha|$.

When the distance that a light ray (the light ray extracted in the normal direction) traveling from the light emitting region 130 to the end portion 203 of the curved surface 201 at an angle $\beta$ travels in a horizontal direction to the main surface 109 of the substrate 101 is defined as L, the area of the incident region 133 is given by $\pi(r - L)^2$, and the area of the light emitting region 130 is given by $\pi a^2$.

Considering the refraction at the interface of each layer provided between the light emitting region 130 and the microlens 107, the distance L is given by calculating the angle of the light ray in each layer of the protective layer 106. More specifically, in a case where N layers (three layers in the example shown in Fig. 9) including the microlens 107 are provided, assuming that the microlens 107 is the first layer, and the ith layer in the stacking order from the first layer has a refractive index $n_i$, a light ray angle $\beta i$ in the ith layer is given by:

$$n_i \cdot \sin\beta i = n_1 \cdot \sin\beta 1 \quad ...(1)$$

A distance Li that the light ray travels in the direction parallel to the main surface of the substrate in each layer is given by Li = $H_i \cdot \tan\beta i$, using the light ray angle βi in each layer. The distance L is given by adding the distances Li in each layer from i = 1 to i = N, as expressed by the following equation (2). Here, $H_i$ is the height of the ith layer in the normal direction to the main surface 109 of the substrate 101. That is, if there are N layers, $H = H_1 + H_2 + H_3 + ... + H_N$.

$$L = H_1 \cdot \tan\beta 1 + H_2 \cdot \tan\beta 2 + ... + H_N \cdot \tan\beta_N \quad ...(2)$$

From the above, it can be understood that $\pi a^2 < \pi(r - L)^2$ holds if the area of the incident region 133 is larger than the area of the light emitting region 130.

The refractive index of the material forming each of the above-described layers can be evaluated by, for example, measuring a sample in which the material is formed into a film on an Si wafer using a measurement method such as spectroscopic ellipsometry. The refractive index may be, for example, the refractive index measured at a wavelength of 500 nm.

In this embodiment, in the pixel 110 arranged in the light emitting device 100, the area of the incident region 133 is larger than the area of the light emitting region 130. With this configuration, it is possible to provide the light emitting device 100 having high display quality by suppressing variation of the luminous intensity in the front direction of the pixel 110 (the normal direction to the main surface 109 of the substrate 101). The reasons for this will be described below.

Figs. 6A and 6B show the configuration of a comparative example where the area of the incident region 133 is smaller than the area of the light emitting region 130 in the pixel 110. Figs. 6A and 6B show the configurations of different pixels 110a and 110b, respectively. The sections of the pixels 110a and 110b are shown on the upper sides of Figs. 6A and 6B, and the sectional profiles of luminance of the light emitting elements 120 (light emitting regions 130) before reaching the microlenses 107 are shown on the lower sides. It can be seen that the luminance distribution in the light emitting region 130, where light is emitted, of the light emitting layer 131 of the pixel 110a is different from the luminance distribution in the light emitting region 130, where light is emitted, of the light emitting layer 131 of the pixel 110b, as shown in Figs. 6A and 6B.

Consider a case where the light emitting device 100 is current-driven, that is, a designated amount of current flows through the light emitting element 120, and the same amount of current flows through the light emitting elements 120. Hence, although the luminance distribution is different between the pixel 110a and the pixel 110b, the total amount of light emitted from the light emitting region 130 is considered to be approximately the same therebetween.

As shown in Figs. 6A and 6B, the area of the incident region 133 is smaller than the area of the light emitting region 130. In this case, as in the pixel 110a shown in Fig. 6A, if the incident region 133 corresponds to the portion where the luminance is low, the light in the low luminance portion is extracted in the front direction of the light emitting device 100 (the normal direction to the main surface 109 of the substrate 101) via the microlens 107. Accordingly, the luminous intensity in the front direction after transmission through the microlens 107 is low. On the other hand, as in the pixel 110b shown in Fig. 6B, if the incident region 133 corresponds to the portion where the luminance is high, the light in the high luminance portion is extracted in the front direction of the light emitting device 100 via the microlens 107. Accordingly, the luminous intensity in the front direction after transmission through the microlens 107 is high. That is, even if the same amount of current flows through the light emitting elements 120 of the pixels 110a and 110b to achieve uniform display, the amount of light extracted in the front direction changes depending on the pixels 110, resulting in ununiform display.

Figs. 7A and 7B show the configuration according to this embodiment where the area of the incident region 133 is larger than the area of the light emitting region 130 in the pixel 110. As in the case shown in Figs. 6A and 6B, the luminance distribution in the light emitting region 130, where light is emitted, of the light emitting layer 131 of the pixel 110a is different from the luminance distribution in the light emitting region 130, where light is emitted, of the light emitting layer 131 of the pixel 110b. As in the above example, consider a case where the same amount of current flows through the light emitting elements 120.

As shown in Figs. 7A and 7B, the area of the incident region 133 is larger than the area of the light emitting region 130. In this case, even if the luminance distribution in the light emitting region 130 is different between the pixel 110a and the pixel 110b, light emitted from the large area of the light emitting region 130 can be extracted in the front direction of the light emitting device 100 (the normal direction to the main surface 109 of the substrate 101). As shown in Fig. 5, the whole outer edge of the light emitting region 130 may be arranged inside the outer edge of the incident region 133. With this, light can be extracted in the front direction from the entire light emitting region 130 via the microlens 107. Hence, if the same amount of current flows through the light emitting elements 120 of the pixels 110a and 110b, the luminous intensity in the front direction after transmission through the microlens 107 also tends to be approximately the same between the pixels 110. This can implement highly uniform display in the light emitting device 100. As a result, the display quality of the light emitting device 100 can be improved.

It can also be said that in the configuration according to this embodiment shown in Figs. 5, 7A, and 7B, the pixel 110 is configured such that the light emitted from the end portion of the light emitting region 130 and passing through the

end portion of the microlens 107, which is nearest to the end portion of the light emitting region 130, is emitted as diverging light due to the power of the microlens 107. In this case, in the orthogonal projection to the main surface 109 of the substrate 101, the whole outer edge of the light emitting region 130 may be arranged inside the outer edge of the microlens 107.

Here, the method of evaluating the luminance distribution in the light emitting region 130 will be described with reference to Fig. 8. As shown in Fig. 8, the microlenses 107 are removed from the light emitting device 100 shown in Fig. 1, the same amount of current is made to flow through the respective light emitting elements 120 to emit light, and a photograph is taken from above using a microscope. In this case, the magnification of the microscope is set such that the light emission distributions of the respective light emitting elements 120 can be seen. For example, a photograph may be taken using an objective lens with a magnification of about 150x. Using such an evaluation system, with respect to the gradations of photographs obtained while changing the luminance of the light emitting element 120 whose luminance is known, the correlation between the gradation of the taken photograph and the luminance is calculated. The luminance distribution before reaching the microlens can be calculated from the gradation of the photograph. Alternatively, it is possible to evaluate the luminance distribution using an evaluation device such as an image colorimeter in which an objective lens and a luminance meter are integrated.

Here, the case where the luminance distribution is different between the pixels 110 can be a case where, as in the pixel 110a and the pixel 110b shown in Figs. 7A and 7B described above, the highest luminance position or the lowest luminance position in the light emitting region 130 is different between the pixels. For example, define a coordinate system when the plurality of pixels 110 are arranged in a matrix. The X direction (for example, the row direction or the like) and the Y direction (for example, the column direction or the like) intersecting (orthogonal to) the X direction may be decided as appropriate. Hereinafter, a description will be given assuming that it is determined whether the luminance distribution is different between the pixel 110a and the pixel 110b among the plurality of pixels 110. The pixel 110a and the pixel 110b may be nearest pixels that emit light of the same color among the plurality of pixels 110. With this, highly uniform display can be implemented in continuous (nearby) regions. However, the disclosure is not limited to this. For example, the pixel 110a and the pixel 110b may be pixels adjacent to each other among the plurality of pixels 110, or one or more pixels 110 may be arranged between the pixel 110a and the pixel 110b.

For example, a coordinate system is defined where the direction from the pixel 110a to the pixel 110b to be compared is the X direction, the direction intersecting the X direction is the Y direction, and the geometric centroid position of the light emitting region 130 in the orthogonal projection to the main surface 109 of the substrate 101 in each of the pixels 110a and 110b is the origin (0, 0). If the coordinate position of the maximum luminance position in the light emitting region 130 of the pixel 110a is different from the coordinate position of the maximum luminance position in the light emitting region 130 of the pixel 110b, it may be determined that the luminance distribution in the light emitting region 130 of the pixel 110a is different from the luminance distribution in the light emitting region 130 of the pixel 110b. For example, the case where the luminance distribution in the light emitting region 130 of the pixel 110a is different from the luminance distribution in the light emitting region 130 of the pixel 110b (to be sometimes referred to that the luminance distribution is different between the pixel 110a and the pixel 110b hereinafter) may be a case where, in this coordinate system, the maximum luminance position in the light emitting region 130 of the pixel 110a is 0.2 $\mu$m or more away from the maximum luminance position in the light emitting region 130 of the pixel 110b. Furthermore, the case where the luminance distribution is different between the pixel 110a and the pixel 110b may be a case where, in this coordinate system, the maximum luminance position in the light emitting region 130 of the pixel 110a is 0.5 $\mu$m or more away from the maximum luminance position in the light emitting region 130 of the pixel 110b. Alternatively, for example, the case where the luminance distribution is different between the pixel 110a and the pixel 110b may be a case where the luminance at the geometric centroid position in the light emitting region 130 of the pixel 110a in the orthogonal projection to the main surface 109 of the substrate 101 is different from the luminance at the geometric centroid position in the light emitting region 130 of the pixel 110b in the orthogonal projection to the main surface 109 of the substrate 101. For example, considering the significant difference in measurement accuracy, if the luminances at the geometric centroid positions are different by 2% or more, it may be determined that the luminance distribution is different between the pixel 110a and the pixel 110b. Alternatively, for example, if the luminances at the geometric centroid positions are different by 5% or more, it may be determined that the luminance distribution is different between the pixel 110a and the pixel 110b. Furthermore, for example, if the luminances at the geometric centroid positions are different by 10% or more, it may be determined that the luminance distribution is different between the pixel 110a and the pixel 110b. Alternatively, for example, if the luminances at the geometric centroid positions are different by 20% or more, it may be determined that the luminance distribution is different between the pixel 110a and the pixel 110b.

When the light emitting device 100 is manufactured inexpensively using a relatively rough process, the luminance distribution in the light emitting region 130 can vary greatly between the pixels 110 (light emitting elements 120). On the other hand, even when the luminance distribution varies greatly as described above, the effect of the disclosure can be greatly enjoyed, and degradation of the display quality of the light emitting device 100 is suppressed. That is, for example, by reducing burden on process management, the light emitting device 100 according to this embodiment can be manufactured at suppressed cost.

In addition, for example, the lower electrode 102 may be formed by including a conductive layer and an oxide

layer covering the conductive layer. That is, the lower electrode 102 may be formed from a plurality of layers. The oxide layer may be a layer that is arranged in the uppermost layer of the lower electrode 102 contacting the organic compound layer 103. If the uppermost layer of the lower electrode 102 is the oxide layer, when manufacturing the light emitting device 100, there is less concern that oxidation of the conductive layer of the lower electrode 102 progresses in the process after the lower electrode 102 is formed. Accordingly, for example, a process of exposing the lower electrode 102 to the atmosphere can be used in a state in which the opening portion 132 is formed in the insulating layer 105 so that the lower electrode 102 is exposed. In other words, a process of exposing the lower electrode 102 to the atmosphere can be used while lowering the resistance of the lower electrode 102 by using a conductive layer having high conductivity. With this, it is unnecessary to manufacture the light emitting device 100 in a vacuum in-situ process from formation of the opening portions 132 in the insulating layer 105 to formation of the organic compound layer 103. That is, the light emitting device 100 can be manufactured at low cost using a relatively simple process. If the uppermost layer of the lower electrode 102 is the oxide layer, since the degree of oxidation tends to vary in the surface of the lower electrode 102 depending on the used process, a resistance distribution readily occurs when injecting charges from the lower electrode 102 to the organic compound layer 103. As a result, the luminance distribution in the light emitting region 130 is likely to vary for each pixel 110. In addition, since the in-plane distribution of thickness of the oxide layer having low conductivity influences the distribution of resistivity of the lower electrode 102, the luminance distribution in the light emitting region 130 is likely to vary for each pixel 110. This configuration can greatly enjoy the effect of the disclosure.

The lower electrode 102 may have a layer configuration in which, for example, a titanium-containing barrier layer is arranged on and in contact with an aluminum-containing layer. Aluminum has a high light reflectance so that it is advantageous for improving the light emitting efficiency of the light emitting element 120. However, when a process involving exposure to the atmosphere is used, an insulating native oxide film is formed on the surface and resistance increases. To avoid this, a titanium-containing barrier layer is formed in the uppermost layer. An oxide layer formed on the surface of titanium has a work function advantageous for hole injection into the organic layer, and is therefore also advantageous for decreasing resistance. It can also be said that the lower electrode 102 includes a conductive layer and an oxide layer covering the conductive layer, and includes a layer using aluminum or the like and constituting a part of the conductive layer, and a layer containing titanium and constituting the remaining part of the conductive layer and the oxide layer. Since titanium has a lower light reflectance than aluminum, it can be used in a thin film form. In this case, a distribution of film thickness of the barrier layer readily occurs in the surface of the lower electrode 102. Since the proportion of aluminum diffusing into the barrier layer and appearing in the surface of the barrier layer changes in accordance with the film thickness, the proportion of aluminum oxide, which has a work function disadvantageous for hole injection into the organic layer, tends to have a distribution in the surface of the lower electrode 102. Accordingly, the luminance distribution in the light emitting region 130 readily varies for each pixel 110. Hence, even this configuration can greatly enjoy the effect of the disclosure. The film thickness of the thinned titanium-containing barrier layer may be, for example, 15 nm or less. Furthermore, for example, the film thickness of the titanium-containing barrier layer may be 10 nm or less. This makes it possible to achieve both requirements for light reflectance and charge injection characteristics.

The conductive layer of the lower electrode 102 may be a layer having a crystal grain boundary. For example, aluminum, silver, or the like used as the conductive layer of the lower electrode 102 may be composed of a plurality of crystal grains. Since the in-plane charge injection characteristic of the lower electrode 102 can change between within the crystal grains and at the crystal grain boundary, the luminance distribution in the light emitting region 130 is likely to vary for each pixel 110. However, as described above, in the light emitting device 100 according to this embodiment, even if the luminance distribution in the light emitting region 130 varies for each pixel 110, degradation of display quality is suppressed. That is, even this configuration can greatly enjoy the effect of the disclosure.

As shown in Fig. 7A, in the orthogonal projection to the main surface 109 of the substrate 101, the light emitting region 130 of the pixel 110a may have a plurality of luminance peak positions. In this case, the luminance distribution tends to be different as compared to the pixel having one luminance peak position like the pixel 110b, or the pixel 110 having a relatively uniform luminance distribution. However, even when the pixel 110 having a plurality of luminance peak positions in the light emitting region 130 is arranged, the effect of the disclosure can be greatly enjoyed.

As described above, when a relatively low-cost process with simple process management is used, unevenness can be generated in the surface of the lower electrode 102 facing the light emitting layer 131. For example, it is conceivable that the surface of the lower electrode 102 has a height difference (Peak to Valley (PV) value) of 10 nm or more, or even 15 nm or more, with the main surface 109 of the substrate 101 as a reference. In this case, the film thickness of the organic compound layer 103 may change in accordance with the unevenness of the surface of the lower electrode 102, and a luminance distribution can occur. In addition, if the surface of the lower electrode 102 is uneven, or due to the process of forming the lower electrode 102, the lower electrode 102 can have an in-plane distribution of reflectance for light emitted from the light emitting region 130. In this case as well, the luminance distribution in the light emitting region 130 can vary for each pixel 110. Even these configurations can greatly enjoy the effect of the disclosure.

An example of a method of manufacturing the light emitting device 100 will be described below. In this example, the light emitting device 100 includes three kinds of light emitting elements 120 including a red light emitting element with a

red light emitting layer, a green light emitting element with a green light emitting layer, and a blue light emitting element with a blue light emitting layer.

First, the structure 108 was formed on the substrate 101. The structure 108 can be formed by forming, for example, one or more layers of wiring patterns and the like in a dielectric. After the structure 108 was formed, an aluminum film was formed on the structure 108, and a plurality of lower electrodes 102 were formed by patterning the aluminum film. Then, the insulating layer 105 was formed to cover each of the plurality of lower electrodes 102. As the insulating layer 105, for example, silicon oxide having a film thickness of 65 nm can be used. After the insulating layer 105 was formed, the opening portions 132 were provided to expose the lower electrodes 102. The shape of the opening portion 132 can be, for example, a circular shape having a radius of 0.9 $\mu$m. As described above, the opening portion 132 of the insulating layer 105 exposes the lower electrode 102 to the organic compound layer 103 formed on the lower electrode 102. In the orthogonal projection to the main surface 109 of the substrate 101, the size and shape of the opening portion 132 can match the size and shape of the light emitting region 130 of the light emitting layer 131.

Next, the organic compound layer 103 was formed on the lower electrodes 102 (and the insulating layer 105). More specifically, first, a hole injection layer, a hole transport layer, and an electron blocking layer were sequentially formed. At this time, the hole injection layer and the hole transport layer may be, for example, deposited to cover the lower electrodes 102 corresponding to all the light emitting elements 120. The electron blocking layer may be, for example, deposited three times using a fine mask so as to be separately formed for each of the lower electrodes 102 corresponding to the light emitting elements 120 corresponding to the respective light emission colors. For the purpose of optimizing the optical distance described above, the film thickness of the electron blocking layer may be adjusted for each light emission color. Next, for example, a red light emitting layer, a green light emitting layer, and a blue light emitting layer were formed by performing deposition using the fine mask three times such that the light emitting layers 131 are separately formed for each light emission color. After the respective light emitting layers 131 were formed, a hole blocking layer and an electron transport layer were sequentially formed. The hole blocking layer may be formed by adjusting the film thickness of the hole blocking layer for each light emission color, similar to the electron blocking layer. Subsequently, an electron injection layer was formed by lithium fluoride.

After the electron injection layer was formed, a magnesium/silver alloy was formed to a thickness of 10 nm as the upper electrode 104 on the organic compound layer 103. The ratio of magnesium and silver may be, for example, 1 : 1. After that, as the protective layer 106, silicon nitride with a refractive index of 1.97 was formed to a thickness of 2.1 $\mu$m on the upper electrode 104 using the CVD method.

After the protective layer 106 was formed, the microlenses 107 with a refractive index of 1.53 were formed on the protective layer 106 using the exposure process and the developing process. The curved surface 201 of the microlens 107 was a part of a spherical surface. For an example, the distance h in the normal direction to the main surface 109 of the substrate 101 from the vertex 202 of the curved surface 201 to the end portion 203 of the curved surface 201 may be 1.4 $\mu$m, and the distance r in the horizontal direction may be 1.9 $\mu$m. A portion above the microlens 107 was air with a refractive index of 1. In this case, by considering the height, from the surface of the protective layer 106, of the microlens 107 of the light emitting element 120 having a high interference order, the difference in view angle characteristic between the pixels having different interference orders can be decreased.

The light emitting device 100 can be manufactured using the steps as described above. Furthermore, as described above, even if a luminance distribution occurs in the light emitting region 130 of the light emitting element 120 due to using a process with simple process management in each step, and therefore the luminance distribution varies between the pixels 110, degradation of the display quality of the light emitting device 100 is suppressed. In other words, the light emitting device 100 with improved quality can be provided at low cost.

The configuration in which a transparent material is used for the lower electrode 102, a reflective layer is provided below (the substrate 101 side) the lower electrode 102, and an insulating film is provided between the lower electrode 102 and the reflective layer to obtain a predetermined optical distance, as described above, will be described here. Fig. 10A is an orthogonal projection view of the light emitting device 100 when viewed from above in the normal direction. Fig. 10B is a sectional view taken along a line X - X' shown in Fig. 10A. In the configuration shown in Fig. 10B, the above-described planarizing layer 115 is arranged between the protective layer 106 and the microlenses 107.

In the configuration shown in Fig. 10B, the light emitting element 120 includes a reflective layer 112 arranged between the lower electrode 102 and the structure 108 arranged on the main surface 109 of the substrate 101. The light emitting element 120 also includes an insulating layer 111 that is arranged between the lower electrode 102 and the reflective layer 112 and functions as an optical adjustment layer for obtaining a predetermined optical distance. The lower electrode 102 and the reflective layer 112 are electrically connected via a conductive via 114 arranged in the insulating layer 111. The reflective layers 112 respectively arranged in the light emitting elements 120 are insulated by an insulating layer 113. The lower electrode 102 and the reflective layer 112 are electrically connected via the conductive via 114. It can also be said that the light emitting element 120 includes the conductive via 114 that electrically connects the lower electrode 102 and the reflective layer 112. Furthermore, the light emitting element 120 includes an insulating layer 151 arranged between the organic compound layer 103 (light emitting layer 131) and the lower electrode 102 and arranged at

the position overlapping the conductive via 114 in the orthogonal projection to the main surface 109 of the substrate 101. Each dashed line c shown in Fig. 10A indicates the intermediate point in the insulating layer 105 between the opening portions 132 of the light emitting elements 120 adjacent to each other. The configuration shown in Figs. 10A and 10B shows an example in which the pixels 110 adjacent to each other emit light of the same color, but the light emitting device 100 is not limited to this configuration. For example, the film thickness of the insulating layer 111 may be different in accordance with the color emitted from the pixel 110. This enables adjustment of the optical interference distance in accordance with the light emission color, thereby obtaining high light emission efficiency.

As the material of the reflective layer 112, a metal such as aluminum or silver, or an alloy thereof added with silicon, copper, nickel, neodymium, or the like can be used. The material of the conductive via 114 may be selected from cobalt, molybdenum, platinum, tantalum, titanium, titanium nitride, tungsten, and the like. The conductive via 114 may be an alloy or a compound. For example, a material containing titanium or titanium nitride as a main component may be used for the conductive via 114. Among these, the conductive via 114 may contain titanium nitride as a main component. A conductive layer made of titanium, titanium nitride, or the like may be provided at the interface between the reflective layer 112 and the insulating layer 111 on the substrate 101 side. The conductive layer arranged on the interface between the reflective layer 112 and the insulating layer 111 can function as a barrier metal. The lower electrode 102 may be made of a transparent conductive oxide such as ITO, IZO, AZO, or IGZO, or may have a layered structure thereof. For the insulating layer 111, a transparent material is used, like an inorganic material such as silicon nitride, silicon oxynitride, or silicon oxide, or an organic material such as a resin.

In the configuration shown in Figs. 10A and 10B, unevenness can be generated in the portion of the lower electrode 102 arranged on the conductive via 114, resulting in generation of unevenness in the portion of the upper electrode 104 arranged on the conductive via 114. Therefore, the insulating layer 151 is arranged in the region on the lower electrode 102 overlapping the conductive via 114 to mitigate the unevenness. In this case, in the orthogonal projection to the main surface 109 of the substrate 101, the relative position, where the conductive via 114 and the insulating layer 151 are arranged, with respect to the geometric centroid position of the light emitting region 130 (opening portion 132) may be different between the light emitting elements 120. The position where the conductive via 114 and the insulating layer 151 are arranged may be intentionally different in consideration of the characteristics, or may be different as a result of process variations. In the region of the light emitting layer 131 overlapping the insulating layer 151 in the orthogonal projection to the main surface 109 of the substrate 101, light is not emitted since no current flows between the lower electrode 102 and the upper electrode 104. Accordingly, the luminance distribution in the light emitting region 130 is different between a light emitting element 120a and a light emitting element 120b shown in Figs. 10A and 10B.

Even in this case, similar to the configuration shown in Figs. 7A and 7B, the area of the incident region 133 is larger than the area of the light emitting region 130 in the pixel 110 according to this embodiment, as shown in Fig. 10A. Hence, even if the luminance distribution in the light emitting region 130 is different between the pixel 110a and the pixel 110b, light emitted from the large area of the light emitting region 130 can be extracted in the front direction of the light emitting device 100 (the normal direction to the main surface 109 of the substrate 101). As shown in Fig.10A, the whole outer edge of the light emitting region 130 may be arranged inside the outer edge of the incident region 133. With this, light can be extracted in the front direction from the entire light emitting region 130 via the microlens 107. Hence, if the same amount of current flows through the light emitting elements 120 of the pixels 110a and 110b, the luminous intensity in the front direction after transmission through the microlens 107 also tends to be approximately the same between the pixels 110. This can implement highly uniform display in the light emitting device 100. As a result, the display quality of the light emitting device 100 can be improved.

In the configuration shown in Figs. 10A and 10B, the insulating layer 151 may not be arranged. In this case, as in the above description, the relative position where the conductive via 114 is arranged with respect to the geometric centroid position of the light emitting region 130 (opening portion 132) in the orthogonal projection to the main surface 109 of the substrate 101 can be different between the light emitting elements 120. In this case, if the reflectance of the conductive via 114 is different from that of the reflective layer 112, the luminance distribution in the light emitting region 130 changes between the light emitting element 120a and the light emitting element 120b. Furthermore, for example, even if the relative position where the conductive via 114 is arranged with respect to the geometric centroid position of the light emitting region 130 (opening portion 132) is the same, if the reflectance of the conductive via 114 is different between the light emitting elements 120, the luminance distribution in the light emitting region changes between the light emitting elements 120 regardless of the presence/absence of the insulating layer 151.

Even in these cases, the area of the incident region 133 is larger than the area of the light emitting region 130 in the pixel 110 according to this embodiment. Accordingly, even if the luminance distribution in the light emitting region 130 is different between the pixels 110, light emitted from the large area of the light emitting region 130 can be extracted in the front direction of the light emitting device 100 (the normal direction to the main surface 109 of the substrate 101). Hence, if the same amount of current flows through the light emitting elements 120 of the respective pixels 110, the luminous intensity in the front direction after transmission through the microlens 107 also tends to be approximately the same between the pixels 110. This can implement highly uniform display in the light emitting device 100. As a result, the display

quality of the light emitting device 100 can be improved.

As in this embodiment, the light emitting element 120 in which the reflective layer 112 is arranged between the lower electrode 102 and the structure 108 and the insulating layer 111 is arranged between the reflective layer 112 and the lower electrode 102, not only the reflective layer 112 has an in-plane distribution of reflectance, but also the insulating layer 111 has an in-plane distribution. Therefore, the luminance distribution in the light emitting region 130 tends to be different between the light emitting elements 120. Furthermore, in the configuration in which the conductive via 114 connecting the lower electrode 102 and the reflective layer 112 is provided, as described above, the luminance distribution in the light emitting region 130 tends to be different between the light emitting elements 120 due to the influence of arranging the conductive via 114. Hence, the configuration where the insulating layer 111 functioning as an optical adjustment layer is arranged between the lower electrode 102 and the reflective layer 112 can greatly enjoy the effect of the disclosure.

Fig. 11 is a view showing a modification of the light emitting element 120 arranged in the pixel 110 shown in Figs. 10A and 10B. In the configuration shown in Fig. 11, the light emitting element 120 does not include the insulating layer 111 functioning as an optical adjustment layer, but includes a conductive layer 116 functioning as an electric corrosion suppression layer between the lower electrode 102 and the reflective layer 112. The remaining configuration may be the same as that described above. The different configuration will mainly be described here, and a description of the configuration that may be the same will be omitted, as appropriate.

The material of the conductive layer 116 may be selected from cobalt, molybdenum, platinum, tantalum, titanium, titanium nitride, tungsten, and the like. The conductive layer 116 may be an alloy or a compound of these materials. For example, the conductive layer 116 may contain titanium nitride as a main component. The film thickness of the conductive layer 116 may be less than 10 nm from the viewpoint of reflectance.

The in-plane distribution of reflectance of the conductive layer 116 can be different between the light emitting elements 120. A material having a lower reflectance than the reflective layer 112 is often used for the conductive layer 116. Accordingly, in order to increase the overall reflectance of the reflective layer 112 and the conductive layer 116, there is a need to thin the conductive layer 116. Since it is difficult to control formation of a thin film during manufacturing, this tends to result in occurrence of an in-plane distribution of reflectance in the conductive layer 116. Therefore, the luminance distribution in the light emitting region 130 tends to be different between the light emitting elements 120.

To the contrary, as in the above description, the area of the incident region 133 is larger than the area of the light emitting region 130 in the pixel 110 according to this embodiment. Accordingly, even if the luminance distribution in the light emitting region 130 is different between the pixel 110a and the pixel 110b, light emitted from the large area of the light emitting region 130 can be extracted in the front direction of the light emitting device 100 (the normal direction to the main surface 109 of the substrate 101). Hence, if the same amount of current flows through the light emitting elements 120 of the respective pixels 110, the luminous intensity in the front direction after transmission through the microlens 107 also tends to be approximately the same between the pixels 110. This can implement highly uniform display in the light emitting device 100. As a result, the display quality of the light emitting device 100 can be improved.

In a case where the reflective layer 112 contains aluminum or silver as a main component, and a sub-component such as copper or nickel is alloyed with the main component, stable conduction with the lower electrode 102 using ITO or IZO is possible in a part of the reflective layer 112 even if the conductive layer 116 is not arranged. In this case as well, an in-plane distribution of reflectance occurs in the reflective layer 112. Even in this case, with the configuration according to this embodiment where the area of the incident region 133 is made larger than the area of the light emitting region 130, the above-described effect can be obtained.

Application examples in which the light emitting device 100 according to this embodiment is applied to an image forming device, a display device, a photoelectric conversion device, an electronic apparatus, an illumination device, a moving body, and a wearable device will now be described with reference to Figs. 12A to 20B. The description will be given assuming that, for example, an organic light emitting element (OLED) (corresponding to the above-described light emitting element 120) such as an organic EL element using an organic light emitting material is arranged in the pixel 110 (to be sometimes referred to as the pixel or the sub-pixel) arranged in the light emitting device 100. Details of each component arranged in the pixel 110 (light emitting element 120) of the above-described light emitting device 100 will be described first, and the application examples will be described after that.

The organic light emitting element according to an embodiment of the disclosure includes a first electrode, a second electrode, and an organic compound layer arranged between these electrodes. One of the first electrode and the second electrode is an anode, and the other is a cathode. In the organic light emitting element according to this embodiment, the organic compound layer may be either a single layer or a stacked body formed by a plurality of layers as long as it includes a light emitting layer. Here, if the organic compound layer is a stacked body formed from a plurality of layers, the organic compound layer may include a hole injection layer, a hole transport layer, an electron blocking layer, a hole/exciton blocking layer, an electron transport layer, an electron injection layer, and the like in addition to the light emitting layer. The light emitting layer may be a single layer or a stacked body formed from a plurality of layers. If the light emitting layer includes a plurality of layers, a charge generation layer may be arranged between the light emitting layers. The charge generation layer may be made of a compound having the LUMO lower than that of the hole transport layer, and

the LUMO of the charge generation layer may be lower than the HOMO of the hole transport layer. Here, the molecular orbital energy of the organic compound layer may be the molecular orbital energy of the organic compound with the largest weight ratio in the organic compound layer.

The description is given here assuming that the closer the HOMO and LUMO are to the vacuum level, the "higher" they are. When the LUMO of the charge generation layer is lower than the HOMO of the hole transport layer, the LUMO of the charge generation layer is closer to the vacuum level than the HOMO of the hole transport layer.

The HOMO and LUMO in this specification can be calculated using molecular orbital calculation. The molecular orbital calculation is executed by a Density Functional Theory (DFT) or the like. A functional may be calculated using B3LYP, and a basic function may be calculated using 6-31G*. Note that molecular orbital calculation can be executed using, for example, Gaussian 09 (Gaussian 09, Revision C.01, M.J. Frisch, G.W. Trucks, H.B. Schlegel, G.E. Scuseria, M.A. Robb, J.R. Cheeseman, G. Scalmani, V. Barone, B. Mennucci, G.A. Petersson, H. Nakatsuji, M. Caricato, X. Li, H.P. Hratchian, A.F. Izmaylov, J. Bloino, G. Zheng, J.L. Sonnenberg, M. Hada, M. Ehara, K. Toyota, R. Fukuda, J. Hasegawa, M. Ishida, T. Nakajima, Y. Honda, O. Kitao, H. Nakai, T. Vreven, J.A. Montgomery Jr., J.E. Peralta, F. Ogliaro, M. Bearpark, J.J. Heyd, E. Brothers, K.N. Kudin, V.N. Staroverov, T. Keith, R. Kobayashi, J. Normand, K. Raghavachari, A. Rendell, J.C. Burant, S.S. Iyengar, J. Tomasi, M. Cossi, N. Rega, J.M. Millam, M. Klene, J.E. Knox, J.B. Cross, V. Bakken, C. Adamo, J. Jaramillo, R. Gomperts, R.E. Stratmann, O. Yazyev, A.J. Austin, R. Cammi, C. Pomelli, J.W. Ochterski, R.L. Martin, K. Morokuma, V.G. Zakrzewski, G.A. Voth, P. Salvador, J.J. Dannenberg, S. Dapprich, A.D. Daniels, O. Farkas, J.B. Foresman, J.V. Ortiz, J. Cioslowski, and D.J. Fox, Gaussian, Inc., Wallingford CT, 2010.)

The HOMO and LUMO in this specification can be calculated using the ionization potential and band gap. The HOMO can be estimated by measuring the ionization potential. The ionization potential can be measured by dissolving the compound to be measured in a solvent such as toluene and using a measuring device such as AC-3. The band gap can be measured by dissolving the compound to be measured in a solvent such as toluene and irradiating it with excitation light. The band gap can be measured by measuring the absorption edge of the excitation light. Alternatively, the band gap can be measured by depositing the compound to be measured on a substrate such as glass, and exposing the deposited film to excitation light. The band gap can be measured by measuring the absorption edge of the absorption spectrum at which the deposited film absorbs excitation light.

The LUMO can be calculated using the band gap and ionization potential value. The LUMO can be estimated by subtracting the ionization potential value from the band gap.

The LUMO can also be estimated from the reduction potential. For example, the one-electron reduction potential is estimated using cyclic voltammetry (CV) measurement. The CV measurement can be performed, for example, in a DMF solution of 0.1 M tetrabutylammonium perchlorate using a reference electrode of $Ag/Ag^+$, a counter electrode of Pt, and a working electrode of glassy carbon. The LUMO can be estimated by adding -4.8 eV to the difference between the reduction potential of the obtained compound and that of ferrocene.

If the organic compound according to this embodiment is contained in the light emitting layer, the light emitting layer may be a layer made of only the organic compound according to this embodiment or a layer made of the organic metal complex according to this embodiment and another compound. Here, if the light emitting layer is a layer made of the organic metal complex according to this embodiment and another compound, the organic compound according to this embodiment may be used as a host or a guest of the light emitting layer. Alternatively, the organic compound may be used as an assist material that can be contained in the light emitting layer. Here, the host is a compound whose mass ratio is largest in the compounds forming the light emitting layer. The guest is a compound whose mass ratio is smaller than that of the host in the compounds forming the light emitting layer, and is a compound responsible for main light emission. The assist material is a compound whose mass ratio is smaller than that of the host in the compounds forming the light emitting layer, and which assists light emission of the guest. Note that the assist material is also called a second host. The host material can be called a first compound, and the assist material as a second compound.

If the organic compound according to an embodiment is used as the guest of the light emitting layer, the concentration of the guest may be 0.01 mass% (inclusive) to 20 mass% (inclusive) relative to the entire light emitting layer, or may be 0.1 mass% (inclusive) to 10 mass% (inclusive). The guest is also called a dopant.

The organic metal complex according to this embodiment can be used as the constituent material of the organic compound layer other than the light emitting layer forming the organic light emitting element according to this embodiment. More specifically, the organic metal complex may be used as the constituent material of an electron transport layer, an electron injection layer, a hole transport layer, a hole injection layer, a hole blocking layer, or the like. In this case, the light emission color of the organic light emitting element is not limited to red. More specifically, it may be white or an intermediate color.

A conventionally known low molecular and high molecular hole injection compound or hole transport compound, a compound serving as a host, a light emitting compound, an electron injection compound or electron transport compound, or the like can be used together as needed. Examples of these compounds will be described below.

As a hole injection/transport material, a material that has a high hole mobility such that hole injection from the anode is facilitated, and injected holes can be transported to the light emitting layer can suitably be used. Also, a material

having a high glass transition point temperature can suitably be used to reduce degradation of film quality such as crystallization in the organic light emitting element. Examples of low molecular and high molecular materials having hole injection/transport performance are a triarylamine derivative, an arylcarbazole derivative, a phenylenediamine derivative, a stilbene derivative, a phthalocyanine derivative, a porphyrin derivative, a poly(vinyl carbazole), a poly(thiophene), and other conductive polymers. The above-described hole injection/transport material can suitably be used for the electron blocking layer as well. Detailed examples of compounds used as the hole injection/transport material will be shown below. The material is not limited to these.

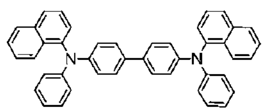
**HT1**

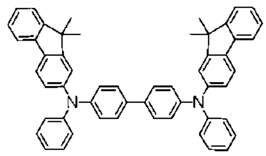
**HT2**

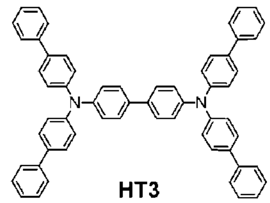
**HT3**

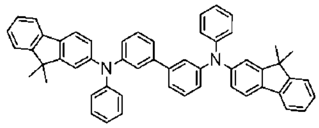
**HT4**

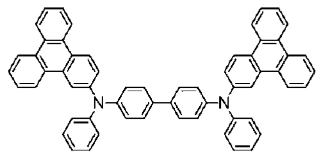
**HT5**

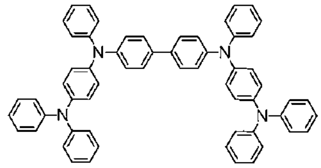
**HT6**

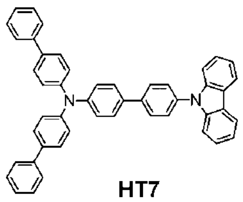
**HT7**

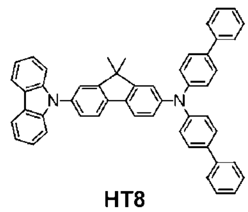
**HT8**

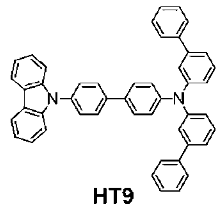
**HT9**

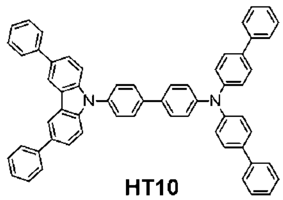
**HT10**

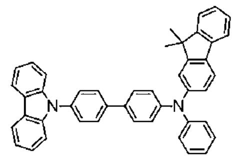
**HT11**

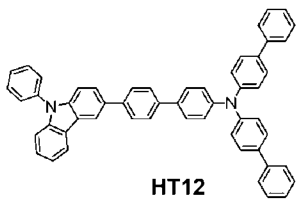
**HT12**

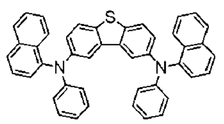
**HT13**

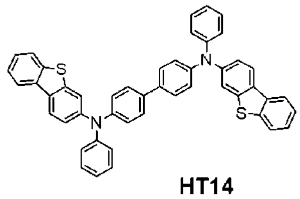
**HT14**

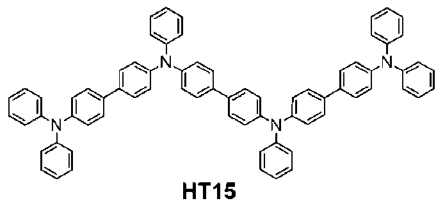
**HT15**

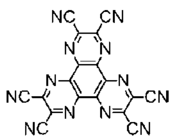
**HT16**

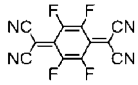
**HT17**

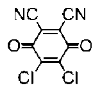
**HT18**

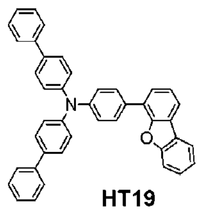
**HT19**

In the hole transport materials, HT16 to HT18 can decrease the driving voltage when used in a layer in contact with the anode. HT16 is widely used in an organic light emitting element. HT2, HT3, HT4, HT5, HT6, HT10, and HT12 can be used in an organic compound layer adjacent to HT16. A plurality of materials may be used in one organic compound

layer.

Examples of the light emitting material mainly concerning the light emitting function are condensed-ring compounds (for example, a fluorene derivative, a naphthalene derivative, a pyrene derivative, a perylene derivative, a tetracene derivative, an anthracene derivative, and rubrene), a quinacridone derivative, a coumarin derivative, a stilbene derivative, an organic aluminum complex such as tris(8-quinolinolato)aluminum, an iridium complex, a platinum complex, a rhenium complex, a copper complex, a europium complex, a ruthenium complex, and polymer derivatives such as a poly(phenylenevinylene) derivative, a poly(fluorene) derivative, and a poly(phenylene) derivative.

Detailed examples of compounds used as the light emitting material will be shown below. The material is not limited to these.

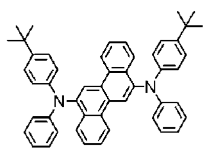
BD1

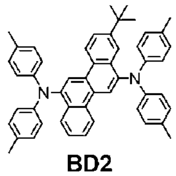
BD2

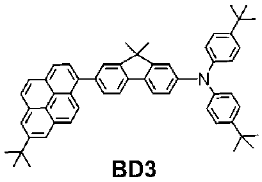
BD3

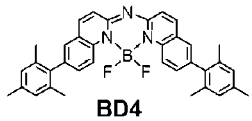
BD4

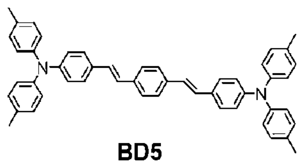
BD5

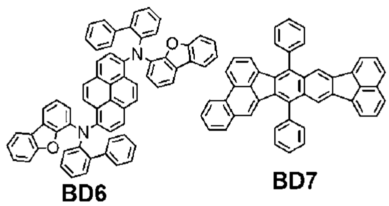
BD6

BD7

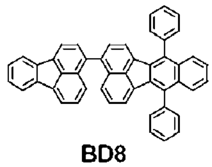
BD8

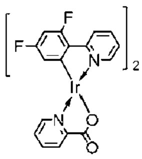
BD9

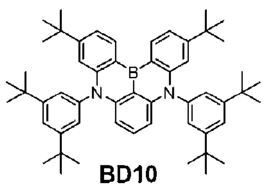
BD10

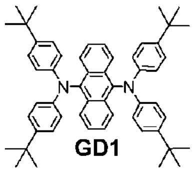
GD1

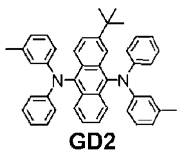
GD2

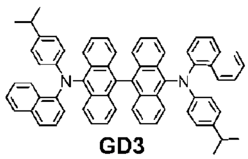
GD3

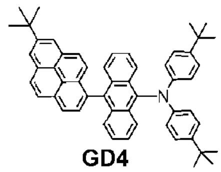
GD4

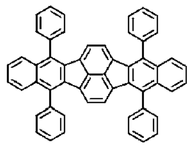
GD5

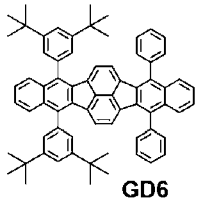
GD6

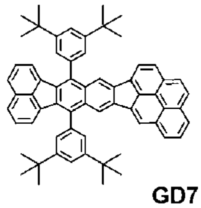
GD7

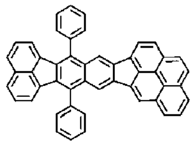
GD8

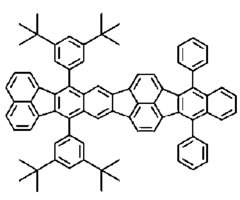
GD9

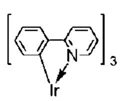
GD10

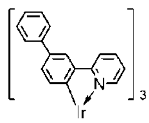
GD11

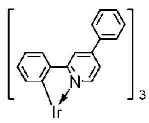
GD12

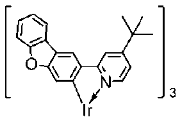
GD13

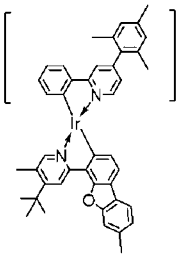
GD14

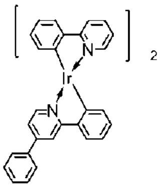
GD15

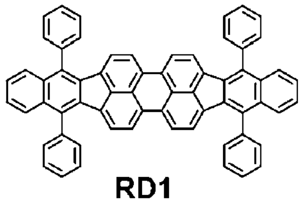
RD1

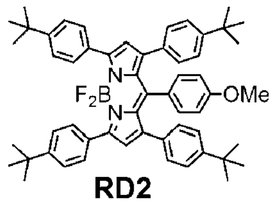
RD2

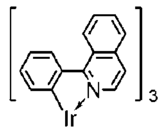
RD3

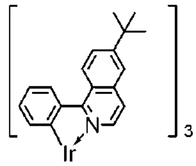
RD4

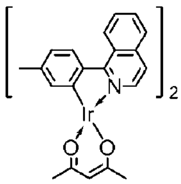
RD5

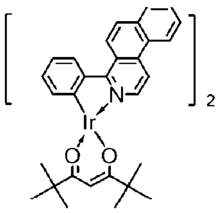
RD6

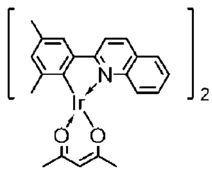
RD7

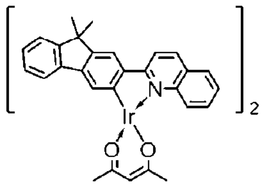
RD8

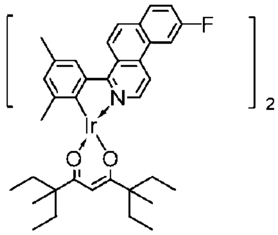
RD9

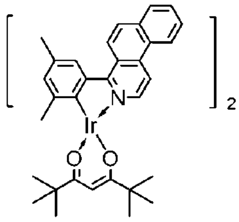
RD10

If the light emitting material is a hydrocarbon compound, this is suitable because it is possible to reduce lowering of light emission efficiency caused by exciplex formation or lowering of color purity due to a change of the light emission spectrum of the light emitting material caused by exciplex formation.

In one embodiment, the hydrocarbon compound is a compound made of only carbon and hydrogen, and includes BD7, BD8, GD5 to GD9, and RD1 in the compounds exemplified above.

If the light emitting material is a condensed polycyclic compound including a 5-membered ring, this is suitable because oxidation hardly occurs because of a high ionization potential, and a long-life element with high durability can be obtained. This includes BD7, BD8, GD5 to GD9, and RD1 in the compounds exemplified above.

Examples of the light emitting layer host or the light emission assist material contained in the light emitting layer are an aromatic hydrocarbon compound or its derivative, a carbazole derivative, a dibenzofuran derivative, a dibenzothiophene derivative, an organic aluminum complex such as tris(8-quinolinolato)aluminum, and an organic beryllium complex.

Detailed examples of compounds used as the light emitting layer host or the light emission assist material contained in the light emitting layer will be shown below. The material is not limited to these.

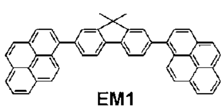
EM1

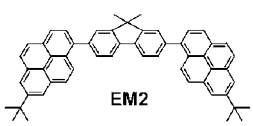
EM2

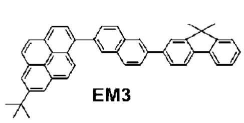
EM3

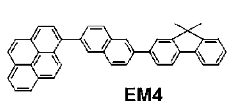
EM4

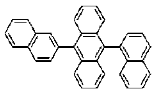 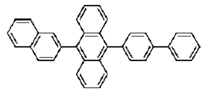 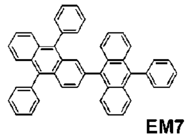 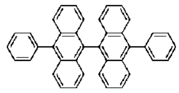

EM5 EM6 EM7 EM8

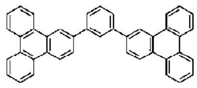 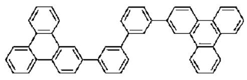 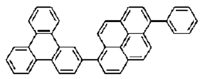 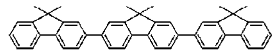

EM9 EM10 EM11 EM12

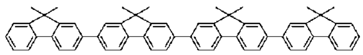 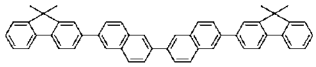 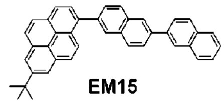

EM13 EM14 EM15

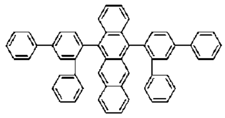 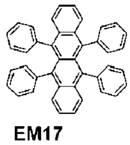 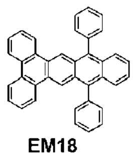 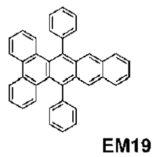

EM16 EM17 EM18 EM19

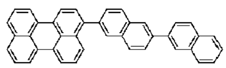 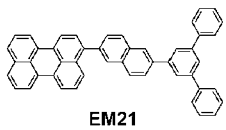 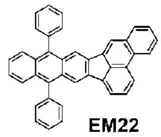 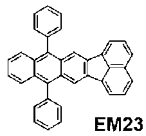

EM20 EM21 EM22 EM23

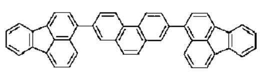 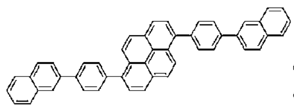 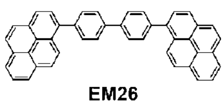 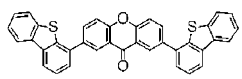

EM24 EM25 EM26 EM27

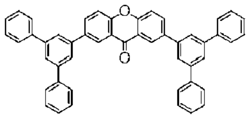 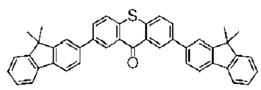 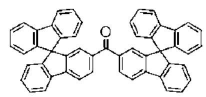 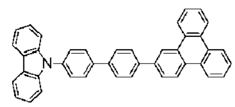

EM28 EM29 EM30 EM31

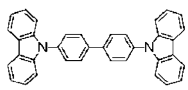

EM32

The host material may be a hydrocarbon compound. In one embodiment, the hydrocarbon compound is a compound made of only carbon and hydrogen, and includes EM1 to EM12 and EM16 to EM27 in the compounds exemplified above. As the host material, a material that has, in a single bond that bonds an aryl group unit in its structure, no carbon-heteroatom bonds, like F3 in compound 1, is suitable from the viewpoint of stability.

The electron transport material can arbitrarily be selected from materials capable of transporting electrons injected from the cathode to the light emitting layer, and is selected in consideration of balance to the hole mobility of the hole transport material. Examples of the material having electron transport performance are an oxadiazole derivative, an oxazole derivative, a pyrazine derivative, a triazole derivative, a triazine derivative, a quinoline derivative, a quinoxaline derivative, a phenanthroline derivative, an organic aluminum complex, and condensed-ring compounds (for example, a fluorene derivative, a naphthalene derivative, a chrysene derivative, and an anthracene derivative). The above-described electron transport material can also be used for the hole blocking layer as well.

Detailed examples of compounds used as the electron transport material will be shown below. The material is not limited to these.

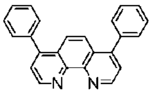 ET1 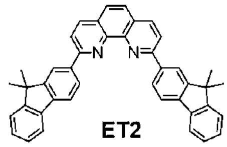 ET2 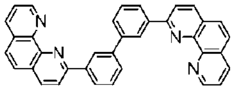 ET3 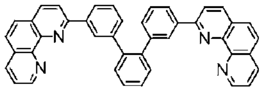 ET4

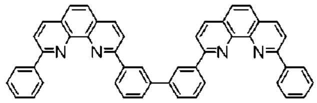 ET5 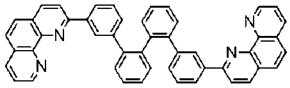 ET6 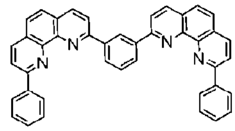 ET7

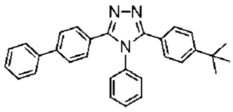 ET8 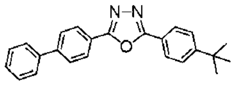 ET9 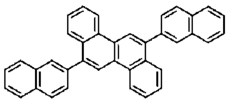 ET10 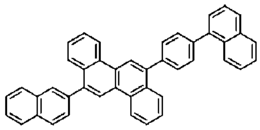 ET11

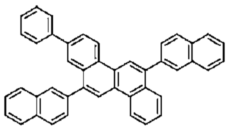 ET12 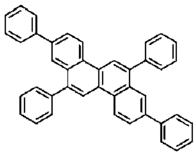 ET13 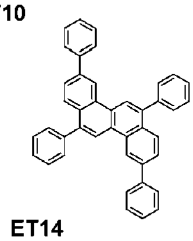 ET14 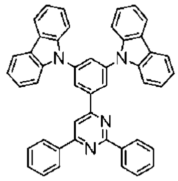 ET15

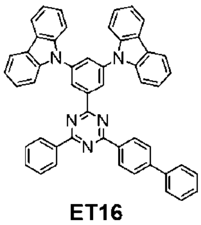 ET16 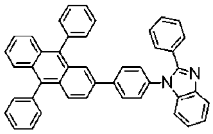 ET17 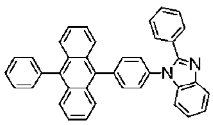 ET18 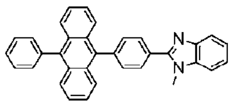 ET19

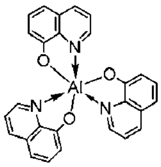 ET20 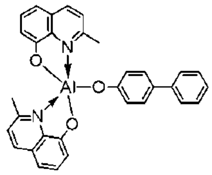 ET21 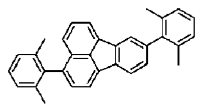 ET22 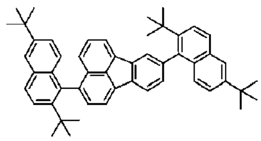 ET23

The electron injection material can arbitrarily be selected from materials capable of facilitating electron injection from the cathode, and is selected in consideration of balance to hole injection. The organic compound includes an n-type dopant and a reducible dopant. Examples are a compound containing an alkali metal such as lithium fluoride, a lithium complex such as a lithium-quinolinol complex, a benzo-imidazolidene derivative, an imidazolidene derivative, a fulvalene derivative, and an acridine derivative.

The electron injection material can also be used together with the above-described electron transport material.

Configuration of Organic Light Emitting Element

The organic light emitting element is provided by forming an insulating layer, a first electrode, an organic compound layer, and a second electrode on a substrate. A protection layer, a color filter, a microlens, and the like may be provided on a cathode. If a color filter is provided, a planarizing layer may be provided between the protection layer and the color filter. The planarizing layer can be formed using acrylic resin or the like. The same applies to a case where a planarizing layer is provided between the color filter and the microlens.

## Substrate

Quartz, glass, a silicon wafer, a resin, a metal, or the like may be used as a substrate. Furthermore, a switching element such as a transistor, a wiring pattern, and the like may be provided on the substrate, and an insulating layer may be provided thereon. The insulating layer may be made of any material as long as a contact hole can be formed so that the wiring pattern can be formed between the first electrode and the substrate and insulation from the unconnected wiring pattern can be ensured. For example, a resin such as polyimide, silicon oxide, silicon nitride, or the like may be used for the insulating layer.

## Electrode

A pair of electrodes can be used as the electrodes. The pair of electrodes can be an anode and a cathode. If an electric field is applied in the direction in which the organic light emitting element emits light, the electrode having a high potential is the anode, and the other is the cathode. It can also be said that the electrode that supplies holes to the light emitting layer is the anode and the electrode that supplies electrons is the cathode.
As the constituent material of the anode, a material having a large work function may be selected. For example, a metal such as gold, platinum, silver, copper, nickel, palladium, cobalt, selenium, vanadium, or tungsten, a mixture containing some of them, an alloy obtained by combining some of them, or a metal oxide such as tin oxide, zinc oxide, indium oxide, indium tin oxide (ITO), or zinc indium oxide can be used. Furthermore, a conductive polymer such as polyaniline, polypyrrole, or polythiophene can also be used as the constituent material of the anode.
One of these electrode materials may be used singly, or two or more of them may be used in combination. The anode may be formed by a single layer or a plurality of layers.
If the electrode is used as a reflective electrode, for example, chromium, aluminum, silver, titanium, tungsten, molybdenum, an alloy thereof, a stacked layer thereof, or the like can be used. The above materials can function as a reflective film having no role as an electrode. If a transparent electrode is used as the electrode, an oxide transparent conductive layer made of indium tin oxide (ITO), indium zinc oxide, or the like can be used, but the disclosure is not limited thereto. A photolithography technique can be used to form the electrode.
On the other hand, as the constituent material of the cathode, a material having a small work function may be selected. Examples of the material include an alkali metal such as lithium, an alkaline earth metal such as calcium, a metal such as aluminum, titanium, manganese, silver, lead, or chromium, and a mixture containing some of them. Alternatively, an alloy obtained by combining these metals can also be used. For example, a magnesium-silver alloy, an aluminum-lithium alloy, an aluminum-magnesium alloy, a silver-copper alloy, a zinc-silver alloy, or the like can be used. A metal oxide such as indium tin oxide (ITO) can also be used. One of these electrode materials may be used singly, or two or more of them may be used in combination. The cathode may have a single-layer structure or a multilayer structure. Silver may be used as the cathode. To suppress aggregation of silver, a silver alloy may be used. The ratio of the alloy is not limited as long as aggregation of silver can be suppressed. For example, the ratio between silver and another metal may be 1 : 1, 3 : 1, or the like.
The cathode may be a top emission element using an oxide conductive layer made of ITO or the like, or may be a bottom emission element using a reflective electrode made of aluminum (Al) or the like, and is not particularly limited. The method of forming the cathode is not particularly limited, but if direct current sputtering or alternating current sputtering is used, the good coverage is achieved for the film to be formed, and the resistance of the cathode can be lowered.

## Pixel Isolation Layer

A pixel isolation layer may be formed by a so-called silicon oxide, such as silicon nitride (SiN), silicon oxynitride (SiON), or silicon oxide (SiO), formed using a Chemical Vapor Deposition (CVD) method. To increase the resistance in the in-plane direction of the organic compound layer, the organic compound layer, especially the hole transport layer may be thinly deposited on the side wall of the pixel isolation layer. More specifically, the organic compound layer can be deposited so as to have a thin film thickness on the side wall by increasing the taper angle of the side wall of the pixel isolation layer or the film thickness of the pixel isolation layer to increase vignetting during vapor deposition.
On the other hand, the taper angle of the side wall of the pixel isolation layer or the film thickness of the pixel isolation layer can be adjusted to the extent that no space is formed in the protection layer formed on the pixel isolation layer. Since no space is formed in the protection layer, it is possible to reduce generation of defects in the protection layer. Since generation of defects in the protection layer is reduced, a decrease in reliability caused by generation of a dark spot or occurrence of a conductive failure of the second electrode can be reduced.
According to this embodiment, even if the taper angle of the side wall of the pixel isolation layer is not acute, it is possible to effectively suppress leakage of charges to an adjacent pixel. As a result of this consideration, it has been found that the taper angle of 60° (inclusive) to 90° (inclusive) can sufficiently reduce the occurrence of defects. The film thickness

of the pixel isolation layer may be 10 nm (inclusive) to 150 nm (inclusive). A similar effect can be obtained in a configuration including only pixel electrodes without the pixel isolation layer. However, in this case, the film thickness of the pixel electrode is set to be equal to or smaller than half the film thickness of the organic layer or the end portion of the pixel electrode is formed to have a forward tapered shape of less than 60°. With this, short circuit of the organic light emitting element can be reduced.

Furthermore, in a case where the first electrode is the cathode and the second electrode is the anode, a high color gamut and low-voltage driving can be achieved by forming the electron transport material and charge transport layer and forming the light emitting layer on the charge transport layer.

Organic Compound Layer

The organic compound layer may be formed by a single layer or a plurality of layers. If the organic compound layer includes a plurality of layers, the layers can be called a hole injection layer, a hole transport layer, an electron blocking layer, a light emitting layer, a hole blocking layer, an electron transport layer, and an electron injection layer in accordance with the functions of the layers. The organic compound layer is mainly formed from an organic compound but may contain inorganic atoms and an inorganic compound. For example, the organic compound layer may contain copper, lithium, magnesium, aluminum, iridium, platinum, molybdenum, zinc, or the like. The organic compound layer may be arranged between the first and second electrodes, and may be arranged in contact with the first and second electrodes. If a plurality of light emitting layers are provided, a charge generation portion may be arranged between the first light emitting layer and the second light emitting layer. The charge generation portion may contain an organic compound with a lowest unoccupied molecular orbital energy (LUMO) of -5.0 eV or less. The same applies to a case where a charge generating portion is provided between the second light emitting layer and the third light emitting layer.

Protection Layer

A protection layer may be provided on the cathode. For example, by adhering glass provided with a moisture absorbing agent on the cathode, permeation of water or the like into the organic compound layer can be suppressed and occurrence of display defects can be suppressed. Furthermore, as another embodiment, a passivation layer made of silicon nitride or the like may be provided on the cathode to suppress permeation of water or the like into the organic compound layer. For example, the protection layer can be formed by forming the cathode, transferring it to another chamber without breaking the vacuum, and forming silicon nitride having a thickness of 2 μm by the CVD method. The protection layer may be provided using an atomic layer deposition (ALD) method after deposition of the protection layer using the CVD method. The material of the protection layer by the ALD method is not limited but can be silicon nitride, silicon oxide, aluminum oxide, or the like. Silicon nitride may further be formed by the CVD method on the protection layer formed by the ALD method. The protection layer formed by the ALD method may have a film thickness smaller than that of the protection layer formed by the CVD method. More specifically, the film thickness of the protection layer formed by the ALD method may be 50% or less, or 10% or less of that of the protection layer formed by the CVD method.

Color Filter

A color filter may be provided on the protection layer. For example, a color filter considering the size of the organic light emitting element may be provided on another substrate, and the substrate with the color filter formed thereon may be bonded to the substrate with the organic light emitting element provided thereon. Alternatively, for example, a color filter may be patterned on the above-described protection layer using a photolithography technique. The color filter may be formed from a polymeric material.

Planarizing Layer

A planarizing layer may be arranged between the color filter and the protection layer. The planarizing layer is provided to reduce unevenness of the layer below the planarizing layer. The planarizing layer may be called a material resin layer without limiting the purpose of the layer. The planarizing layer may be formed from an organic compound, and may be made of a low-molecular material or a polymeric material. In consideration of reduction of unevenness, a polymeric organic compound may be used for the planarizing layer.

The planarizing layers may be provided above and below the color filter. In that case, the same or different constituent materials may be used for these planarizing layers. More specifically, examples of the material of the planarizing layer include polyvinyl carbazole resin, polycarbonate resin, polyester resin, ABS resin, acrylic resin, polyimide resin, phenol resin, epoxy resin, silicone resin, and urea resin.

Microlens

The organic light emitting device may include an optical member such as a microlens on the light emission side. The microlens can be made of acrylic resin, epoxy resin, or the like. The microlens can aim to increase the amount of light extracted from the organic light emitting device and control the direction of light to be extracted. The microlens can have a hemispherical shape. If the microlens has a hemispherical shape, among tangents contacting the hemisphere, there is a tangent parallel to the insulating layer, and the contact between the tangent and the hemisphere is the vertex of the microlens. The vertex of the microlens can be decided in the same manner even in an arbitrary sectional view. That is, among tangents contacting the semicircle of the microlens in a sectional view, there is a tangent parallel to the insulating layer, and the contact between the tangent and the semicircle is the vertex of the microlens.
Furthermore, the middle point of the microlens can also be defined. In the section of the microlens, a line segment from a point at which an arc shape ends to a point at which another arc shape ends is assumed, and the middle point of the line segment can be called the middle point of the microlens. A section for determining the vertex and the middle point may be a section perpendicular to the insulating layer.
The microlens includes a first surface including a convex portion and a second surface opposite to the first surface. The second surface can be arranged on the functional layer (light emitting layer) side of the first surface. For this configuration, the microlens needs to be formed on the light emitting device. If the functional layer is an organic layer, a process which produces high temperature in the manufacturing step of the microlens may be avoided. In addition, if it is configured to arrange the second surface on the functional layer side of the first surface, all the glass transition temperatures of an organic compound forming the organic layer may be 100°C or more. For example, 130°C or more is suitable.

Counter Substrate

A counter substrate may be arranged on the planarizing layer. The counter substrate is called a counter substrate because it is provided at a position corresponding to the above-described substrate. The constituent material of the counter substrate can be the same as that of the above-described substrate. If the above-described substrate is the first substrate, the counter substrate can be the second substrate.

Organic Layer

The organic compound layer (hole injection layer, hole transport layer, electron blocking layer, light emitting layer, hole blocking layer, electron transport layer, electron injection layer, and the like) forming the organic light emitting element according to an embodiment of the disclosure may be formed by the method to be described below.
The organic compound layer forming the organic light emitting element according to the embodiment of the disclosure can be formed by a dry process using a vacuum deposition method, an ionization deposition method, a sputtering method, a plasma method, or the like. Instead of the dry process, a wet process that forms a layer by dissolving a solute in an appropriate solvent and using a well-known coating method (for example, a spin coating method, a dipping method, a casting method, an LB method, an inkjet method, or the like) can be used.
Here, when the layer is formed by a vacuum deposition method, a solution coating method, or the like, crystallization or the like hardly occurs and excellent temporal stability is obtained. Furthermore, when the layer is formed using a coating method, it is possible to form the film in combination with a suitable binder resin.
Examples of the binder resin include polyvinyl carbazole resin, polycarbonate resin, polyester resin, ABS resin, acrylic resin, polyimide resin, phenol resin, epoxy resin, silicone resin, and urea resin. However, the binder resin is not limited to them.
One of these binder resins may be used singly as a homopolymer or a copolymer, or two or more of them may be used in combination. Furthermore, additives such as a well-known plasticizer, antioxidant, and an ultraviolet absorber may also be used as needed.

Pixel Circuit

The light emitting device can include a pixel circuit connected to the light emitting element. The pixel circuit may be an active matrix circuit that individually controls light emission of the first and second light emitting elements. The active matrix circuit may be a voltage or current programing circuit. A driving circuit includes a pixel circuit for each pixel. The pixel circuit can include a light emitting element, a transistor for controlling light emission luminance of the light emitting element, a transistor for controlling a light emission timing, a capacitor for holding the gate voltage of the transistor for controlling the light emission luminance, and a transistor for connection to GND without intervention of the light emitting element.
The light emitting device includes a display region and a peripheral region arranged around the display region.

The light emitting device includes the pixel circuit in the display region and a display control circuit in the peripheral region. The mobility of the transistor forming the pixel circuit may be smaller than that of a transistor forming the display control circuit.

The slope of the current-voltage characteristic of the transistor forming the pixel circuit may be smaller than that of the current-voltage characteristic of the transistor forming the display control circuit. The slope of the current-voltage characteristic can be measured by a so-called Vg-Ig characteristic.

The transistor forming the pixel circuit is a transistor connected to the light emitting element such as the first light emitting element.

Pixel

The organic light emitting device includes a plurality of pixels. Each pixel includes sub-pixels that emit light components of different colors. The sub-pixels may include, for example, R, G, and B emission colors, respectively.

In each pixel, a region also called a pixel opening emits light. The pixel opening can have a size of 5 μm (inclusive) to 15 μm (inclusive). More specifically, the pixel opening can have a size of 11 μm, 9.5 μm, 7.4 μm, 6.4 μm, or the like.

A distance between the sub-pixels can be 10 μm or less, and can be, more specifically, 8 μm, 7.4 μm, or 6.4 μm.

The pixels can have a known arrangement form in a plan view. For example, the pixels may have a stripe arrangement, a delta arrangement, a pentile arrangement, or a Bayer arrangement. The shape of each sub-pixel in a plan view may be any known shape. For example, a quadrangle such as a rectangle or a rhombus, a hexagon, or the like may be possible. A shape which is not a correct shape but is close to a rectangle is included in a rectangle, as a matter of course. The shape of the sub-pixel and the pixel arrangement can be used in combination.

Application of Organic Light Emitting Element of Embodiment of Disclosure

The organic light emitting element according to an embodiment of the disclosure can be used as a constituent member of a display device or an illumination device. In addition, the organic light emitting element is applicable to the exposure light source of an electrophotographic image forming device, the backlight of a liquid crystal display device, a light emitting device including a color filter in a white light source, and the like.

The display device may be an image information processing device that includes an image input unit for inputting image information from an area CCD, a linear CCD, a memory card, or the like, and an information processing unit for processing the input information, and displays the input image on a display unit.

In addition, a display unit included in an image capturing device or an inkjet printer can have a touch panel function. The driving type of the touch panel function may be an infrared type, a capacitance type, a resistive film type, or an electromagnetic induction type, and is not particularly limited. The display device may be used for the display unit of a multifunction printer.

More details will be described next with reference to the accompanying drawings. Fig. 12A shows an example of the pixel arranged in the light emitting device 100. The pixel includes sub-pixels 810. The sub-pixels are divided into sub-pixels 810R, 810G, and 810B by light emission colors. The light emission colors may be discriminated by the wavelengths of light components emitted from the light emitting layers, or light emitted from each sub-pixel may be selectively transmitted or undergo color conversion by a color filter or the like. Each sub-pixel includes a reflective electrode 802 as the first electrode on an interlayer insulating layer 801, an insulating layer 803 covering the end of the reflective electrode 802, an organic compound layer 804 covering the first electrode and the insulating layer, a transparent electrode 805 as the second electrode, a protection layer 806, and a color filter 807.

The interlayer insulating layer 801 can include a transistor and a capacitive element arranged in the interlayer insulating layer 801 or a layer below it. The transistor and the first electrode can electrically be connected via a contact hole (not shown) or the like.

The insulating layer 803 can also be called a bank or a pixel isolation film. The insulating layer 803 covers the end of the first electrode, and is arranged to surround the first electrode. A portion of the first electrode where no insulating layer 803 is arranged is in contact with the organic compound layer 804 to form a light emitting region.

The organic compound layer 804 includes a hole injection layer 841, a hole transport layer 842, a first light emitting layer 843, a second light emitting layer 844, and an electron transport layer 845.

The second electrode may be a transparent electrode, a reflective electrode, or a semi-transmissive electrode.

The protection layer 806 suppresses permeation of water into the organic compound layer. The protection layer is shown as a single layer but may include a plurality of layers. Each layer can be an inorganic compound layer or an organic compound layer.

The color filter 807 is divided into color filters 807R, 807G, and 807B by colors. The color filters can be formed on a planarizing film (not shown). A resin protection layer (not shown) may be arranged on the color filters. The color filters can be formed on the protection layer 806. Alternatively, the color filters can be provided on the counter substrate such as a

glass substrate, and then the substrate may be bonded.

A light emitting device 800 shown in Fig. 12B is provided with an organic light emitting element 826 as an example of a light emitting element and a TFT 818 as an example of a transistor. A substrate 811 of glass, silicon, or the like is provided and an insulating layer 812 is provided on the substrate 811. The active element such as the TFT 818 is arranged on the insulating layer, and a gate electrode 813, a gate insulating film 814, and a semiconductor layer 815 of the active element are arranged. The TFT 818 further includes the semiconductor layer 815, a drain electrode 816, and a source electrode 817. An insulating film 819 is provided on the TFT 818. The source electrode 817 and an anode 821 forming the organic light emitting element 826 are connected via a contact hole 820 formed in the insulating film.

A method of electrically connecting the electrodes (anode and cathode) included in the organic light emitting element 826 and the electrodes (source electrode and drain electrode) included in the TFT is not limited to that shown in Fig. 12B. That is, one of the anode and cathode and one of the source electrode and drain electrode of the TFT are electrically connected. The TFT indicates a thin-film transistor.

In the light emitting device 800 shown in Fig. 12B, an organic compound layer is illustrated as one layer. However, an organic compound layer 822 may include a plurality of layers. A first protection layer 824 and a second protection layer 825 are provided on a cathode 823 to suppress deterioration of the organic light emitting element.

A transistor is used as a switching element in the light emitting device 800 shown in Fig. 12B, but another switching element may be used instead.

The transistor used in the light emitting device 800 shown in Fig. 12B is not limited to a transistor using a single-crystal silicon wafer, and may be a thin-film transistor including an active layer on an insulating surface of a substrate. Examples of the active layer include single-crystal silicon, amorphous silicon, non-single-crystal silicon such as microcrystalline silicon, and a non-single-crystal oxide semiconductor such as indium zinc oxide and indium gallium zinc oxide. Note that a thin-film transistor is also called a TFT element.

The transistor included in the light emitting device 800 shown in Fig. 12B may be formed in the substrate such as a silicon substrate. Forming the transistor in the substrate means forming the transistor by processing the substrate such as a silicon substrate. That is, when the transistor is included in the substrate, it can be considered that the substrate and the transistor are formed integrally.

The light emission luminance of the organic light emitting element according to this embodiment can be controlled by the TFT which is an example of a switching element, and the plurality of organic light emitting elements can be provided in a plane to display an image with the light emission luminances of the respective elements. Here, the switching element according to this embodiment is not limited to the TFT, and may be a transistor formed from low-temperature polysilicon or an active matrix driver formed on the substrate such as a silicon substrate. The term "on the substrate" may mean "in the substrate". Whether to provide a transistor in the substrate or use a TFT is selected based on the size of the display unit. For example, if the size is about 0.5 inch, the organic light emitting element may be provided on the silicon substrate.

Figs. 13A to 13C are schematic views showing an example of an image forming device using the light emitting device 100 according to this embodiment. An image forming device 926 shown in Fig. 13A includes a photosensitive member 927, an exposure light source 928, a developing unit 931, a charging unit 930, a transfer device 932, a conveyance unit 933 (a conveyance roller in the configuration shown in Fig. 13A), and a fixing device 935.

Light 929 is emitted from the exposure light source 928, and an electrostatic latent image is formed on the surface of the photosensitive member 927. The light emitting device 100 can be applied to the exposure light source 928. The developing unit 931 can function as a developing device that includes a toner or the like as a developing agent and applies the developing agent to the exposed photosensitive member 927. The charging unit 930 charges the photosensitive member 927. The transfer device 932 transfers the developed image to a print medium 934. The conveyance unit 933 conveys the print medium 934. The print medium 934 can be, for example, paper, a film, or the like. The fixing device 935 fixes the image formed on the print medium.

Each of Figs. 13B and 13C is a schematic view showing a form in which a plurality of light emitting units 936 are arranged in the exposure light source 928 along the longitudinal direction of a long substrate. The light emitting device 100 can be applied to each of the light emitting units 936. That is, a plurality of the pixels 110 are arranged along the longitudinal direction of the substrate. A direction 937 is a direction parallel to the axis of the photosensitive member 927. This column direction matches the direction of the axis upon rotating the photosensitive member 927. This direction 937 can also be referred to as the long-axis direction of the photosensitive member 927.

Fig. 13B shows a form in which the light emitting units 936 are arranged along the long-axis direction of the photosensitive member 927. Fig. 13C shows a form, which is a modification of the configuration of the light emitting units 936 shown in Fig. 13B, in which the light emitting units 936 are arranged in the column direction alternately between the first column and the second column. The light emitting units 936 are arranged at different positions in the row direction between the first column and the second column. In the first column, the plurality of light emitting units 936 are arranged apart from each other. In the second column, the light emitting unit 936 is arranged at the position corresponding to the space between the light emitting units 936 in the first column. Furthermore, in the row direction, the plurality of light emitting units 936 are

arranged apart from each other. The arrangement of the light emitting units 936 shown in Fig. 13C can be referred to as, for example, an arrangement in a grid pattern, an arrangement in a staggered pattern, or an arrangement in a checkered pattern.

Fig. 14 is a schematic view showing an example of the display device using the light emitting device 100 according to this embodiment. A display device 1000 can include a touch panel 1003, a display panel 1005, a frame 1006, a circuit board 1007, and a battery 1008 between an upper cover 1001 and a lower cover 1009. Flexible printed circuits (FPCs) 1002 and 1004 are respectively connected to the touch panel 1003 and the display panel 1005. An active element such as a transistor is arranged on the circuit board 1007. The battery 1008 is unnecessary if the display device 1000 is not a portable apparatus. Even when the display device 1000 is a portable apparatus, the battery 1008 need not be provided at this position. The light emitting device 100 can be applied to the display panel 1005. The pixels 110 arranged in the light emitting device 100 functioning as the display panel 1005 are connected to the control circuit including the active element such as a transistor arranged on the circuit board 1007 and operate.

The display device 1000 shown in Fig. 14 can be used for a display unit of a photoelectric conversion device (also referred to as an image capturing device) including an optical unit having a plurality of lenses, and an image sensor for receiving light having passed through the optical unit and photoelectrically converting the light into an electric signal. The photoelectric conversion device can include a display unit for displaying information acquired by the image sensor. In addition, the display unit can be either a display unit exposed outside the photoelectric conversion device, or a display unit arranged in the finder. The photoelectric conversion device can be a digital camera or a digital video camera.

Fig. 15 is a schematic view showing an example of the photoelectric conversion device using the light emitting device 100 according to this embodiment. A photoelectric conversion device 1100 can include a viewfinder 1101, a rear display 1102, an operation unit 1103, and a housing 1104. The photoelectric conversion device 1100 can also be called an image capturing device. The light emitting device 100 according to this embodiment can be applied to the viewfinder 1101 or the rear display 1102 as a display unit. In this case, the light emitting device 100 can display not only an image to be captured but also environment information, image capturing instructions, and the like. Examples of the environment information are the intensity and direction of external light, the moving velocity of an object, and the possibility that an object is covered with an obstacle.

The timing suitable for image capturing is a very short time in many cases, it is better to display the information as soon as possible. Therefore, the light emitting device 100 in which the pixel 110 including the light emitting element 120 using the organic light emitting material such as an organic EL element is arranged may be used for the viewfinder 1101 or the rear display 1102. This is so because the organic light emitting material has a high response speed. In one embodiment, the light emitting device 100 using the organic light emitting material can be used for the devices that require a high display speed more suitably than for the liquid crystal display device.

The photoelectric conversion device 1100 includes an optical unit (not shown). This optical unit has a plurality of lenses, and forms an image on a photoelectric conversion element (not shown) that receives light having passed through the optical unit and is accommodated in the housing 1104. The focal points of the plurality of lenses can be adjusted by adjusting the relative positions. This operation can also automatically be performed.

The light emitting device 100 may be applied to a display unit of an electronic apparatus. At this time, the display unit can have both a display function and an operation function. Examples of the portable terminal are a portable phone such as a smartphone, a tablet, and a head mounted display.

Fig. 16 is a schematic view showing an example of an electronic apparatus using the light emitting device 100 according to this embodiment. An electronic apparatus 1200 includes a display unit 1201, an operation unit 1202, and a housing 1203. The housing 1203 can accommodate a circuit, a printed board having this circuit, a battery, and a communication unit. The operation unit 1202 can be a button or a touch-panel-type reaction unit. The operation unit 1202 can also be a biometric authentication unit that performs unlocking or the like by authenticating the fingerprint. The portable apparatus including the communication unit can also be regarded as a communication apparatus. The light emitting device 100 according to this embodiment can be applied to the display unit 1201.

Figs. 17A and 17B are schematic views showing examples of the display device using the light emitting device 100 according to this embodiment. Fig. 17A shows a display device such as a television monitor or a PC monitor. A display device 1300 includes a frame 1301 and a display unit 1302. The light emitting device 100 according to this embodiment can be applied to the display unit 1302. The display device 1300 can include a base 1303 that supports the frame 1301 and the display unit 1302. The base 1303 is not limited to the form shown in Fig. 17A. For example, the lower side of the frame 1301 may also function as the base 1303. In addition, the frame 1301 and the display unit 1302 can be bent. The radius of curvature in this case can be 5,000 mm (inclusive) to 6,000 mm (inclusive).

Fig. 17B is a schematic view showing another example of the display device using the light emitting device 100 according to this embodiment. A display device 1310 shown in Fig. 17B can be folded, and is a so-called foldable display device. The display device 1310 includes a first display unit 1311, a second display unit 1312, a housing 1313, and a bending point 1314. The light emitting device 100 according to this embodiment can be applied to each of the first display unit 1311 and the second display unit 1312. The first display unit 1311 and the second display unit 1312 can also be one

seamless display device. The first display unit 1311 and the second display unit 1312 can be divided by the bending point. The first display unit 1311 and the second display unit 1312 can display different images, and can also display one image together.

Fig. 18 is a schematic view showing an example of the illumination device using the light emitting device 100 according to this embodiment. An illumination device 1400 can include a housing 1401, a light source 1402, a circuit board 1403, an optical film 1404, and a light diffusing unit 1405. The light emitting device 100 according to this embodiment can be applied to the light source 1402. The optical film 1404 can be a filter that improves the color rendering of the light source. When performing lighting-up or the like, the light diffusing unit 1405 can throw the light of the light source over a broad range by effectively diffusing the light. The illumination device can also include a cover on the outermost portion, as needed. The illumination device 1400 can include both or one of the optical film 1404 and the light diffusing unit 1405.

The illumination device 1400 is, for example, a device for illuminating the interior of the room. The illumination device 1400 can emit white light, natural white light, or light of any color from blue to red. The illumination device 1400 can also include a light control circuit for controlling these light components. The illumination device 1400 can also include a power supply circuit connected to the light emitting device 100 functioning as the light source 1402. The power supply circuit is a circuit for converting an AC voltage into a DC voltage. White has a color temperature of 4,200 K, and natural white has a color temperature of 5,000 K. The illumination device 1400 may also include a color filter. In addition, the illumination device 1400 can include a heat radiation unit. The heat radiation unit radiates the internal heat of the device to the outside of the device, and examples are a metal having a high specific heat and liquid silicon.

Fig. 19A is a schematic view of an automobile having a taillight as an example of a vehicle lighting appliance using the light emitting device 100 according to this embodiment. An automobile 1500 has a taillight 1501, and can have a form in which the taillight 1501 is turned on when performing a braking operation or the like. The light emitting device 100 according to this embodiment can be used as a headlight serving as a vehicle lighting appliance.

The light emitting device 100 according to this embodiment can be applied to the taillight 1501. The taillight 1501 can include a protection member for protecting the light emitting device 100 functioning as the taillight 1501. The material of the protection member is not limited as long as the material is a transparent material with a strength that is high to some extent, and an example is polycarbonate. The protection member may be made of a material obtained by mixing a furandicarboxylic acid derivative, an acrylonitrile derivative, or the like in polycarbonate.

The automobile 1500 can include a vehicle body 1503, and a window 1502 attached to the vehicle body 1503. This window can be a window for checking the front and back of the automobile, and can also be a transparent display such as a head-up display. For this transparent display, the light emitting device 100 according to this embodiment may be used. In this case, the constituent materials of the electrodes and the like of the light emitting device 100 are formed by transparent members.

As shown in Fig. 19B, the automobile 1500 can include a steering wheel 1504 that controls the moving direction of the moving body (automobile), and a display unit 1505 that is mounted on the vehicle body 1503 and displays a map, the position of the moving body, a turning direction, the visual field on the rear side of the moving body, and the like. The light emitting device 100 according to this embodiment can be applied to the display unit 1505.

The automobile 1500 is an example of the moving body, and the moving body according to this embodiment includes one or both of a driving force generation unit that generates a driving force mainly used for moving the moving body and a rotating body mainly used for moving the moving body. The driving force generation unit can be an engine, a motor, or the like. The rotating body can be a tire, a wheel, a ship screw, an aircraft propeller or fan, or the like. More specifically, the moving body may be a bicycle, an automobile, a train, a ship, an aircraft, a drone, or the like. The moving body may include a main body and a lighting appliance provided in the main body. The lighting appliance may be used to make a notification of the current position of the main body. The lighting appliance may include the light emitting device 100 according to this embodiment. The display unit may include the light emitting device 100 according to this embodiment.

Further application examples of the light emitting device 100 according to this embodiment will be described with reference to Figs. 20A and 20B. The light emitting device 100 can be applied to a system that can be worn as a wearable device such as smartglasses, a Head Mounted Display (HMD), or a smart contact lens. An image capturing display device used for such application examples includes an image capturing device capable of photoelectrically converting visible light and a light emitting device capable of emitting visible light.

Glasses 1600 (smartglasses) according to one application example will be described with reference to Fig. 20A. An image capturing device 1602 such as a CMOS sensor or an SPAD is provided on the surface side of a lens 1601 of the glasses 1600. In addition, the light emitting device 100 according to this embodiment is provided on the back surface side of the lens 1601.

The glasses 1600 further include a control device 1603. The control device 1603 functions as a power supply that supplies electric power to the image capturing device 1602 and the light emitting device 100 according to each embodiment. In addition, the control device 1603 controls the operations of the image capturing device 1602 and the light emitting device 100. An optical system configured to condense light to the image capturing device 1602 is formed on the lens 1601.

Glasses 1610 (smartglasses) according to one application example will be described with reference to Fig. 20B. The glasses 1610 include a control device 1612, and an image capturing device corresponding to the image capturing device 1602 and the light emitting device 100 are mounted on the control device 1612. The image capturing device in the control device 1612 and an optical system configured to project light emitted from the light emitting device 100 are formed in a lens 1611, and an image is projected to the lens 1611. The control device 1612 functions as a power supply that supplies electric power to the image capturing device and the light emitting device 100, and controls the operations of the image capturing device and the light emitting device 100. The control device 1612 may include a line-of-sight detection unit that detects the line of sight of a wearer. The detection of a line of sight may be done using infrared rays. An infrared ray emitting unit emits infrared rays to an eyeball of the user who is gazing at a displayed image. An image capturing unit including a light receiving element detects reflected light of the emitted infrared rays from the eyeball, thereby obtaining a captured image of the eyeball. A reduction unit for reducing light from the infrared ray emitting unit to the display unit in a planar view is provided, thereby reducing deterioration of image quality.

The line of sight of the user to the displayed image is detected from the captured image of the eyeball obtained by capturing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The light emitting device 100 according to this embodiment of the disclosure can include an image capturing device including a light receiving element, and control a displayed image based on the line-of-sight information of the user from the image capturing device.

More specifically, the light emitting device 100 decides a first visual field region at which the user is gazing and a second visual field region other than the first visual field region based on the line-of-sight information. The first visual field region and the second visual field region may be decided by the control device of the light emitting device 100, or those decided by an external control device may be received. In the display region of the light emitting device 100, the display resolution of the first visual field region may be controlled to be higher than the display resolution of the second visual field region. That is, the resolution of the second visual field region may be lower than that of the first visual field region.

In addition, the display region includes a first display region and a second display region different from the first display region, and a region of higher priority is decided from the first display region and the second display region based on line-of-sight information. The first display region and the second display region may be decided by the control device of the light emitting device 100, or those decided by an external control device may be received. The resolution of the region of higher priority may be controlled to be higher than the resolution of the region other than the region of higher priority. That is, the resolution of the region of relatively low priority may be low.

Note that AI may be used to decide the first visual field region or the region of higher priority. The AI may be a model configured to estimate the angle of the line of sight and the distance to a target ahead the line of sight from the image of the eyeball using the image of the eyeball and the direction of actual viewing of the eyeball in the image as supervised data. The AI program may be held by the light emitting device 100, the image capturing device, or an external device. If the external device holds the AI program, it is transmitted to the light emitting device 100 via communication.

When performing display control based on line-of-sight detection, smartglasses further including an image capturing device configured to capture the outside can be applied. The smartglasses can display captured outside information in real time.

According to the disclosure, a technique advantageous in improving the display quality of a light emitting device can be provided.

Various embodiments have been described in detail above but it will be understood that the present disclosure is not limited to these embodiments and encompasses all modifications, variants, alternatives and equivalents falling within the scope of the appended claims.

## Claims

**1.** A light emitting device including a first pixel (110a) and a second pixel (110b), wherein

each of the first pixel (110a) and the second pixel (110b) includes a microlens (107) arranged above a main surface (109) of a substrate (101), and a light emitting element (120) arranged between the main surface (109) and the microlens (107),

the light emitting element (120) includes a light emitting layer (131), **characterized in that**

a luminance distribution in a light emitting region (130) of the light emitting layer (131) of the first pixel (110a) and a luminance distribution in a light emitting region (130) of the light emitting layer (131) of the second pixel (110b) are different from each other, and
in each of the first pixel (110a) and the second pixel (110b), the microlens (107) is arranged at a position where, in a case where light enters toward the light emitting layer (131) while passing through the microlens (107) from a normal direction of the main surface (109), an area of an incident region (133) where a light beam having passed through the entire microlens (107) enters in a plane parallel to the main surface (109) and including an upper surface of the light emitting layer (131), becomes larger than an area of the light emitting region (130).

2. The light emitting device according to claim 1, **characterized in that** in each of the first pixel and the second pixel, a whole outer edge of the light emitting region is arranged inside an outer edge of the incident region in a planar view.

3. The light emitting device according to claim 1 or 2, **characterized in that**

the device includes a plurality of pixels including the first pixel and the second pixel, and
the first pixel and the second pixel are nearest pixels that emit light of the same color among the plurality of pixels.

4. The light emitting device according to any one of claims 1 to 3, **characterized in that** in each of the first pixel and the second pixel, in a coordinate system where a direction from the first pixel to the second pixel is a first direction, a direction intersecting the first direction is a second direction, and a geometric centroid position of the light emitting region in an orthogonal projection to the main surface is an origin, a coordinate position of a first position where luminance is maximum in the light emitting region of the first pixel and a coordinate position of a second position where luminance is maximum in the light emitting region of the second pixel are different from each other.

5. The light emitting device according to claim 4, **characterized in that** in the coordinate system, the first position and the second position are not less than 0.2 μm away from each other.

6. The light emitting device according to claim 4 or 5, **characterized in that** in the coordinate system, the first position and the second position are not less than 0.5 μm away from each other.

7. The light emitting device according to any one of claims 1 to 6, **characterized in that** a luminance at a geometric centroid position in the light emitting region of the first pixel in an orthogonal projection to the main surface and a luminance at a geometric centroid position in the light emitting region of the second pixel in an orthogonal projection to the main surface are different from each other.

8. The light emitting device according to any one of claims 1 to 7, **characterized in that** a luminance at a geometric centroid position in the light emitting region of the first pixel in an orthogonal projection to the main surface and a luminance at a geometric centroid position in the light emitting region of the second pixel in an orthogonal projection to the main surface are different by not less than 2%.

9. The light emitting device according to any one of claims 1 to 8, **characterized in that** a luminance at a geometric centroid position in the light emitting region of the first pixel in an orthogonal projection to the main surface and a luminance at a geometric centroid position in the light emitting region of the second pixel in an orthogonal projection to the main surface are different by not less than 5%.

10. The light emitting device according to any one of claims 1 to 9, **characterized in that** a luminance at a geometric centroid position in the light emitting region of the first pixel in an orthogonal projection to the main surface and a luminance at a geometric centroid position in the light emitting region of the second pixel in an orthogonal projection to the main surface are different by not less than 10%.

11. The light emitting device according to any one of claims 1 to 10, **characterized in that** in an orthogonal projection to the main surface, a light emitting region of the first pixel has a plurality of luminance peak positions.

12. The light emitting device according to any one of claims 1 to **11, characterized in that**

the light emitting element includes a lower electrode arranged between the light emitting layer and the main surface, and
the lower electrode includes a conductive layer and an oxide layer covering the conductive layer.

**13.** The light emitting device according to any one of claims 1 to 12, **characterized in that**

the light emitting element includes a lower electrode arranged between the light emitting layer and the main surface, and
the lower electrode has an in-plane distribution of reflectance for light emitted from the light emitting region.

**14.** The light emitting device according to any one of claims 1 to 13, **characterized in that** the light emitting element includes a lower electrode arranged between the light emitting layer and the main surface, a reflective layer arranged between the lower electrode and the main surface, and an insulating layer arranged between the lower electrode and the reflective layer.

**15.** A display device **characterized by** comprising:

the light emitting device according to any one of claims 1 to 14; and
a control circuit connected to the light emitting device.

**16.** A photoelectric conversion device **characterized by** comprising:

an optical unit including a plurality of lenses;
an image sensor configured to receive light having passed through the optical unit; and
a display configured to display an image,
wherein the display includes the light emitting device according to any one of claims 1 to 14.

**17.** An electronic apparatus **characterized by** comprising:

a housing provided with a display; and
a communication unit provided in the housing and configured to perform external communication,
wherein the display includes the light emitting device according to any one of claims 1 to 14.

**18.** An illumination device **characterized by** comprising:

a light source; and
at least one of a light diffusing unit and an optical film,
wherein the light source includes the light emitting device according to any one of claims 1 to 14.

**19.** A moving body **characterized by** comprising:

a main body; and
a display provided in the main body,
wherein the display includes the light emitting device according to any one of claims 1 to 14.

**20.** A wearable device **characterized by** comprising:

a display device configured to display an image,
wherein the display device includes the light emitting device according to any one of claims 1 to 14.

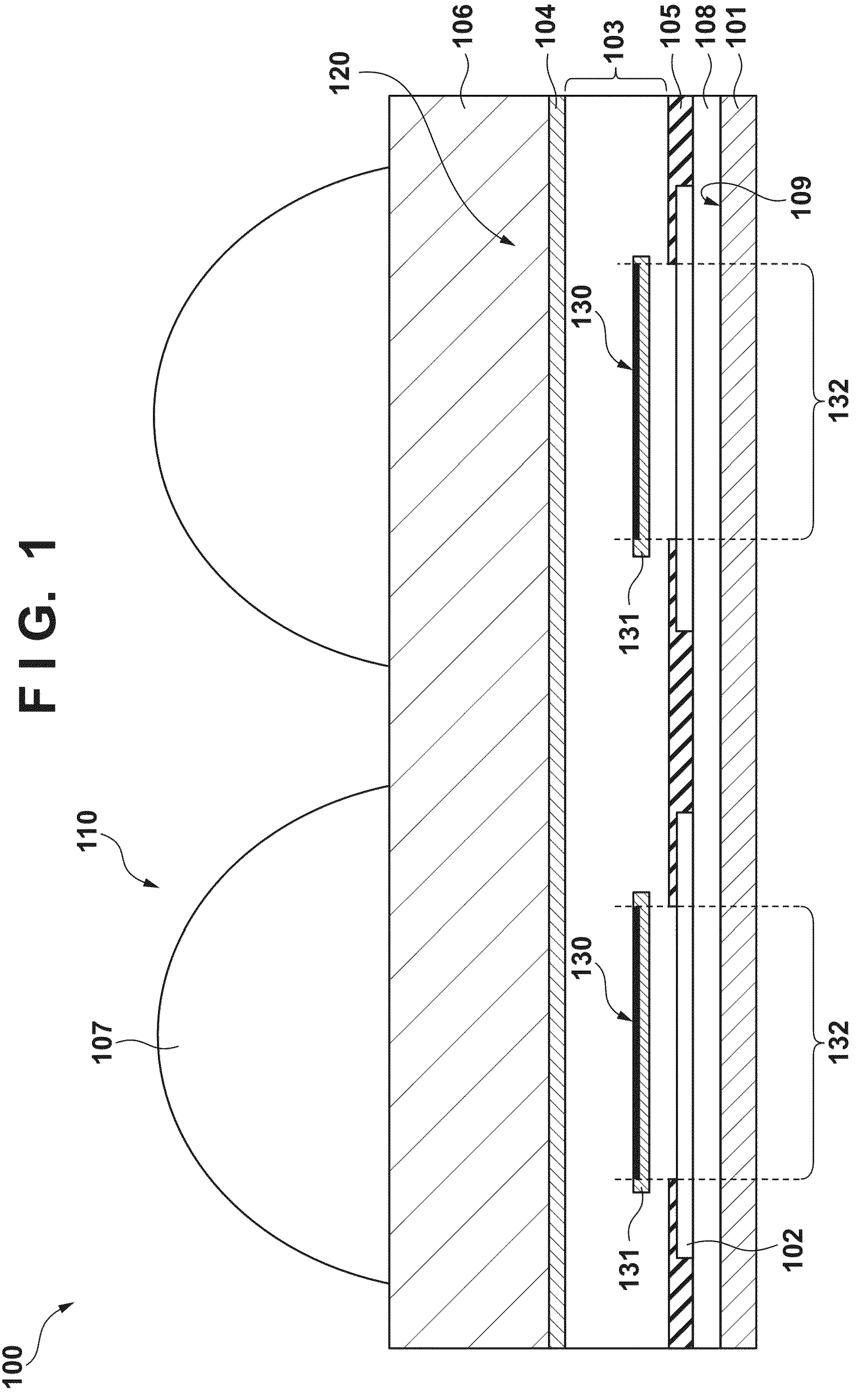


FIG. 1

FIG. 2

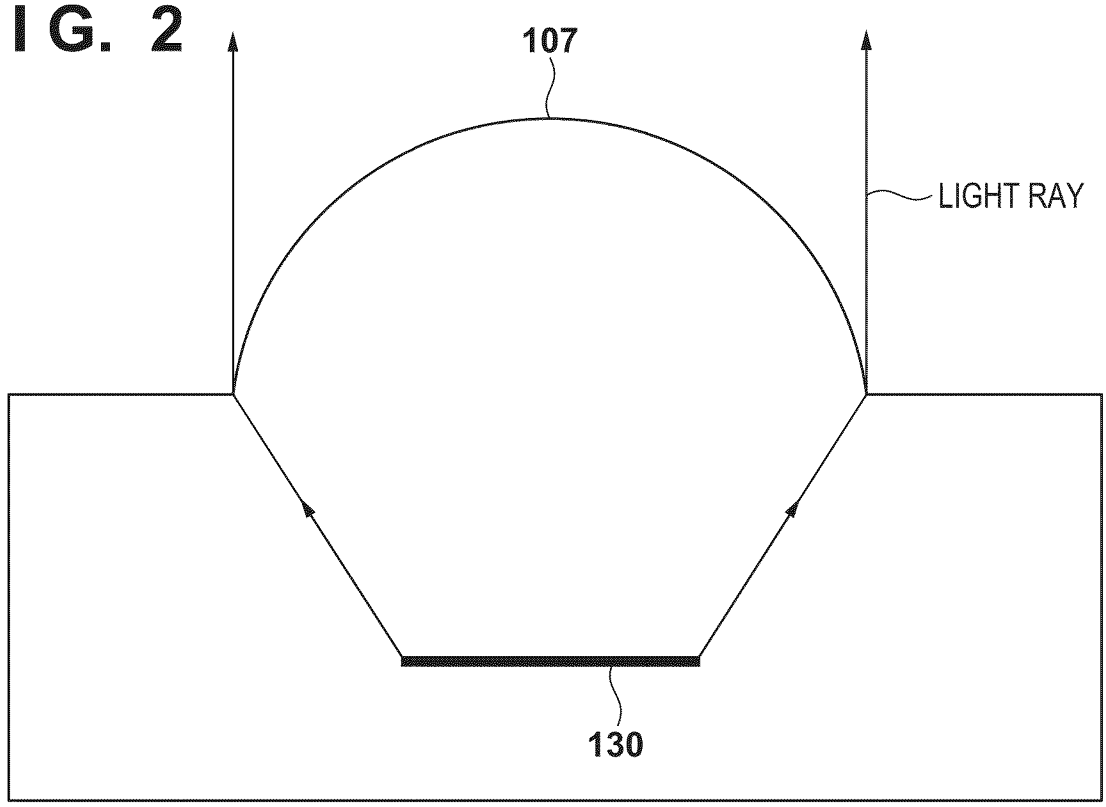


FIG. 3

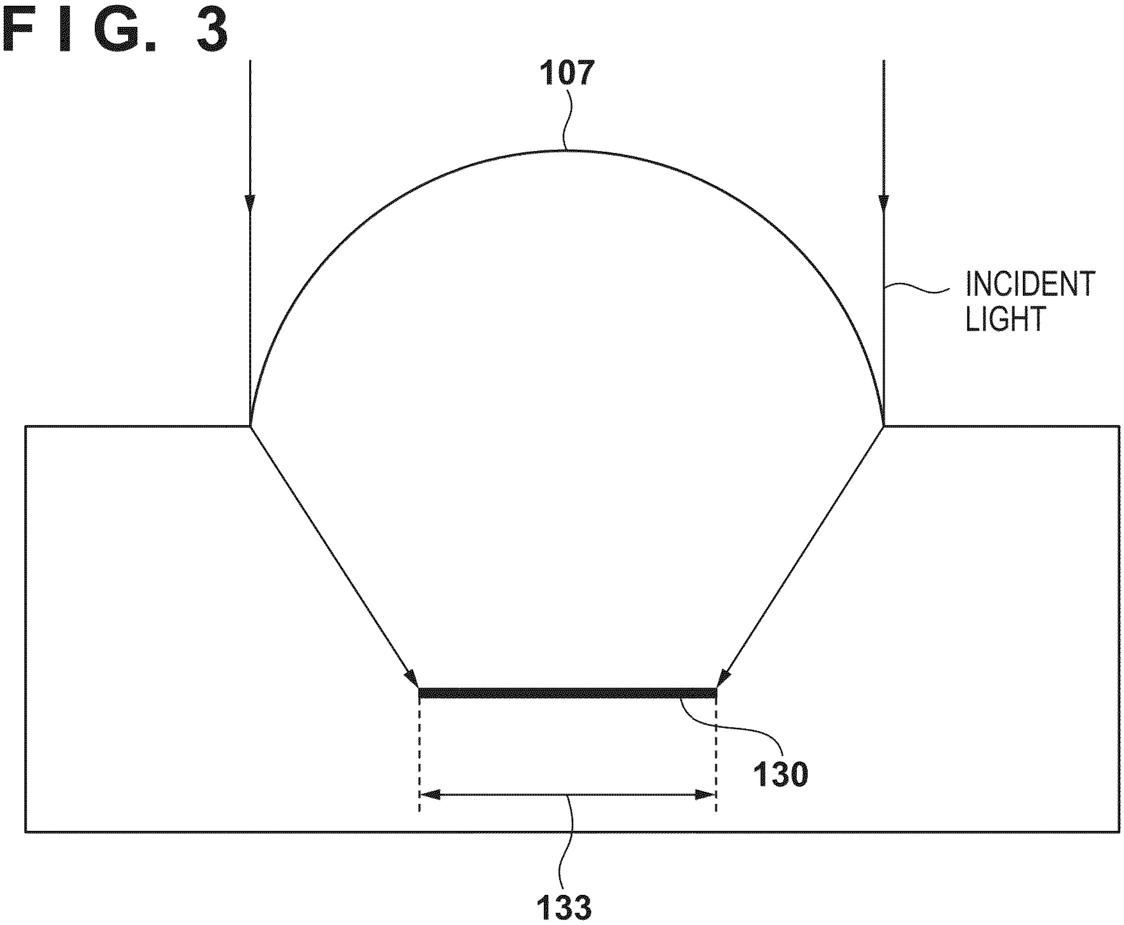

# FIG. 4

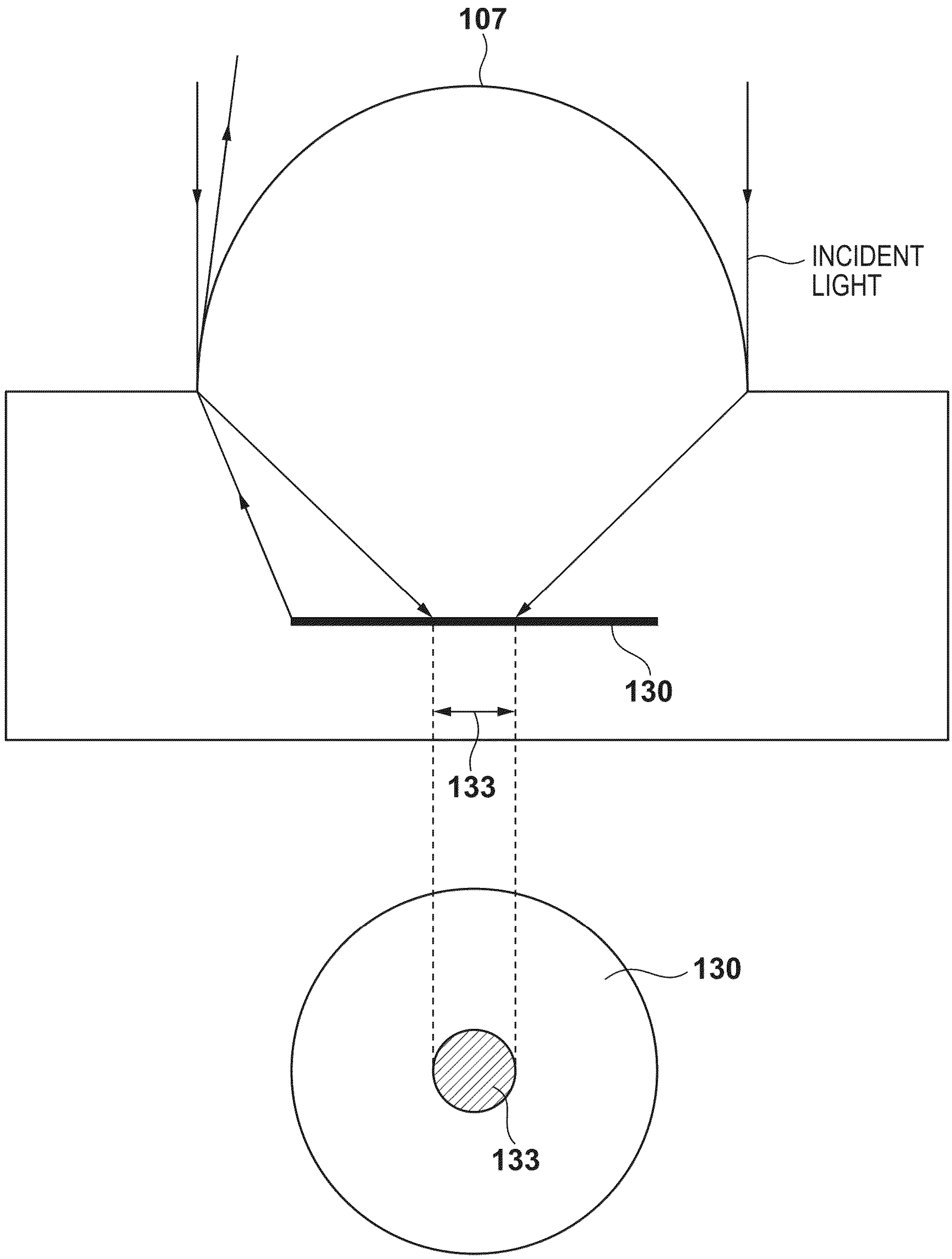

FIG. 5

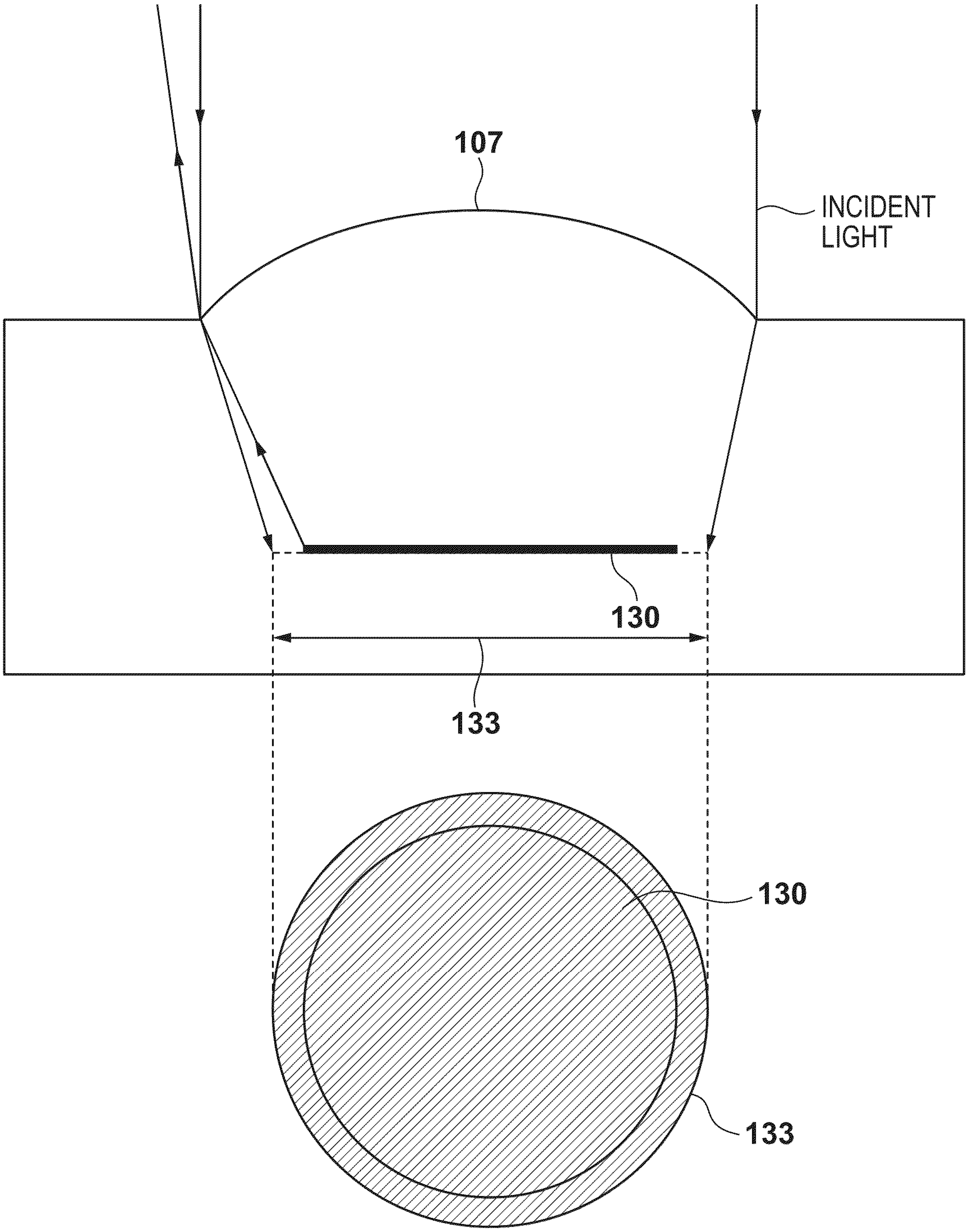

FIG. 6B

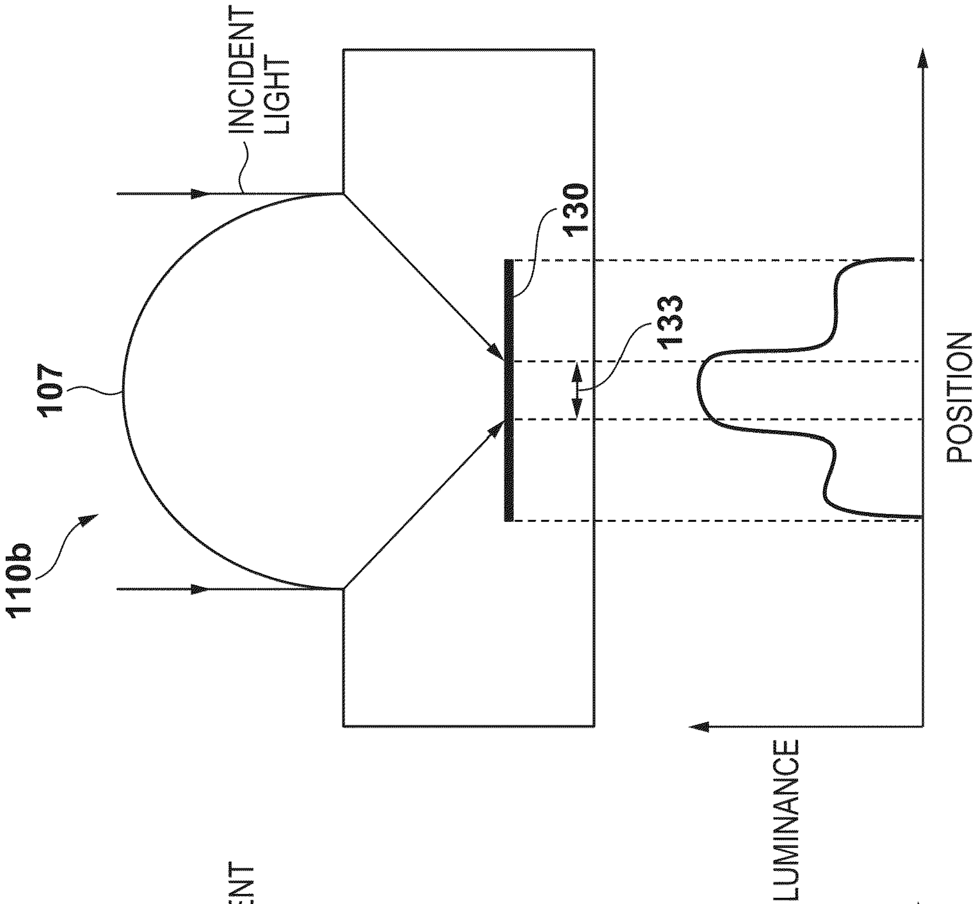
110b
107
INCIDENT LIGHT
130
133
POSITION
LUMINANCE

FIG. 6A

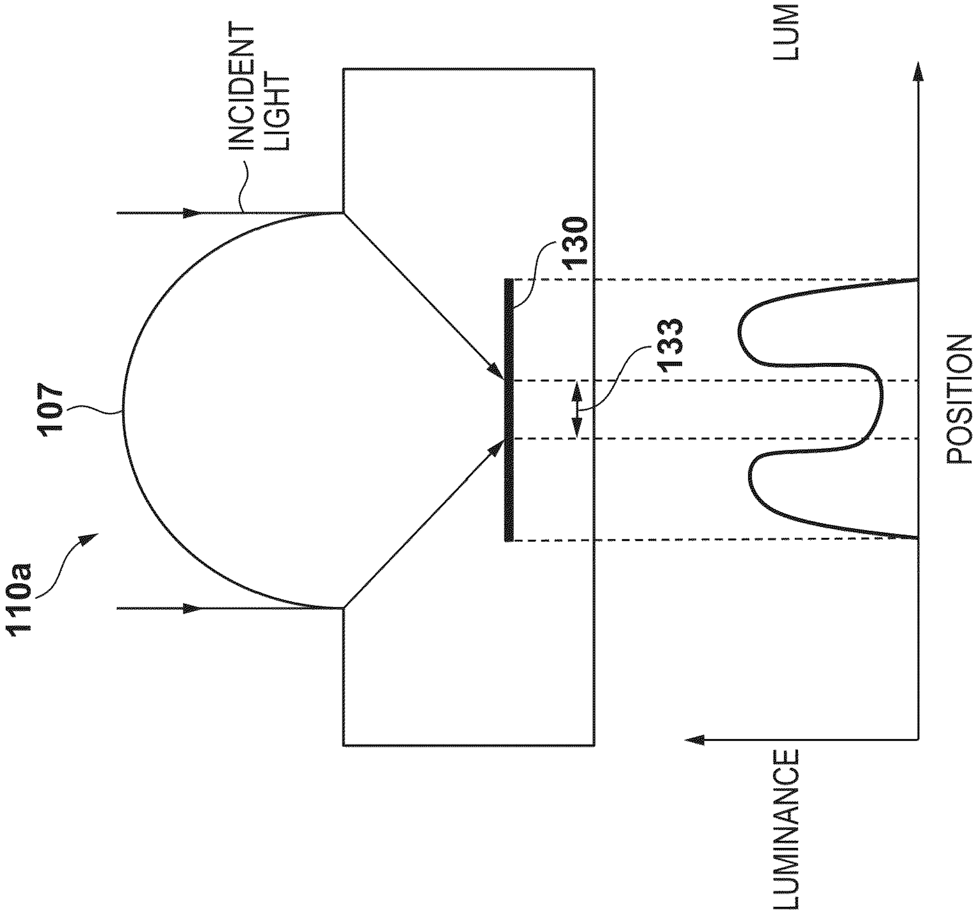
110a
107
INCIDENT LIGHT
130
133
POSITION
LUMINANCE

FIG. 7A

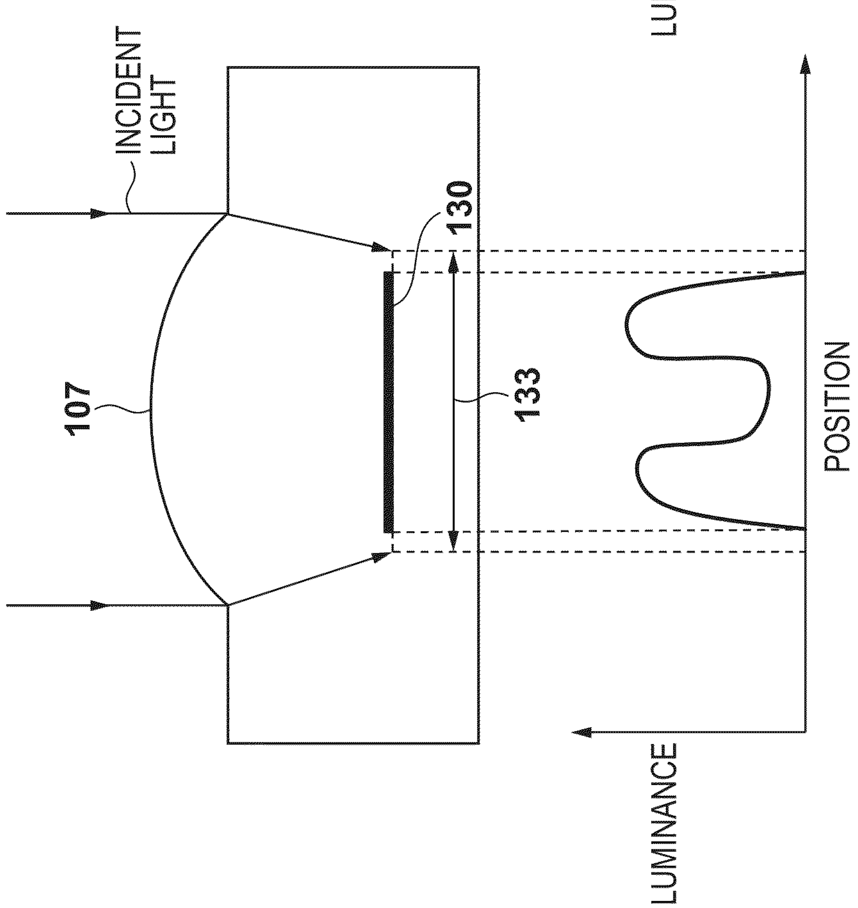
INCIDENT LIGHT
107
130
133
LUMINANCE
POSITION

FIG. 7B

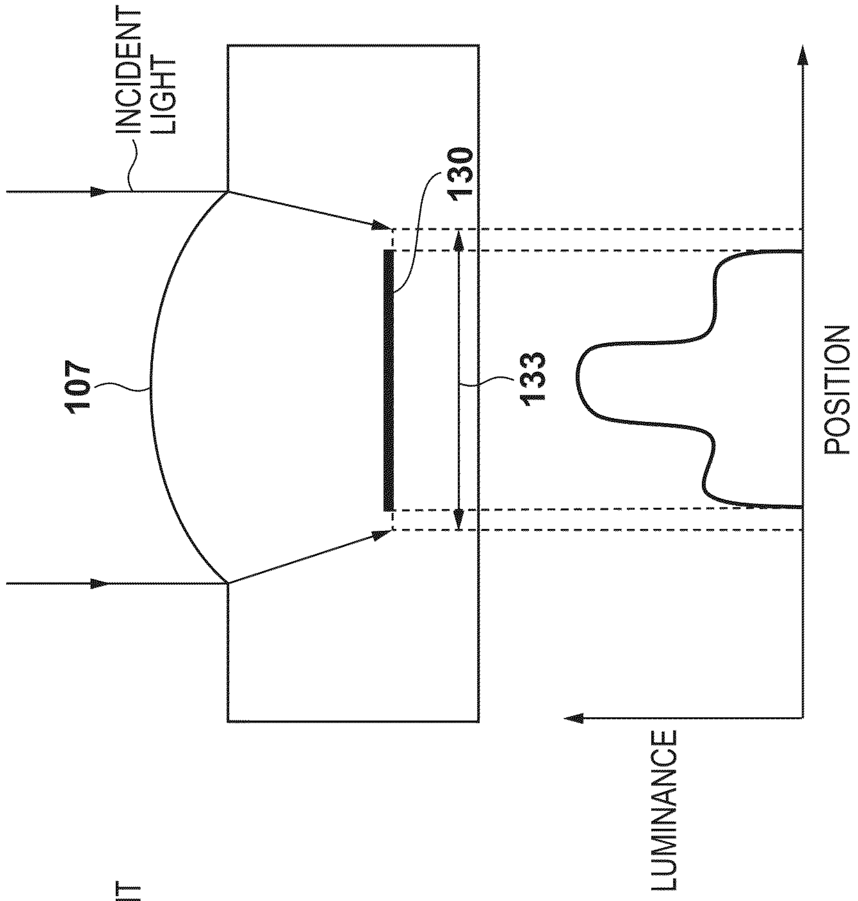
INCIDENT LIGHT
107
130
133
LUMINANCE
POSITION

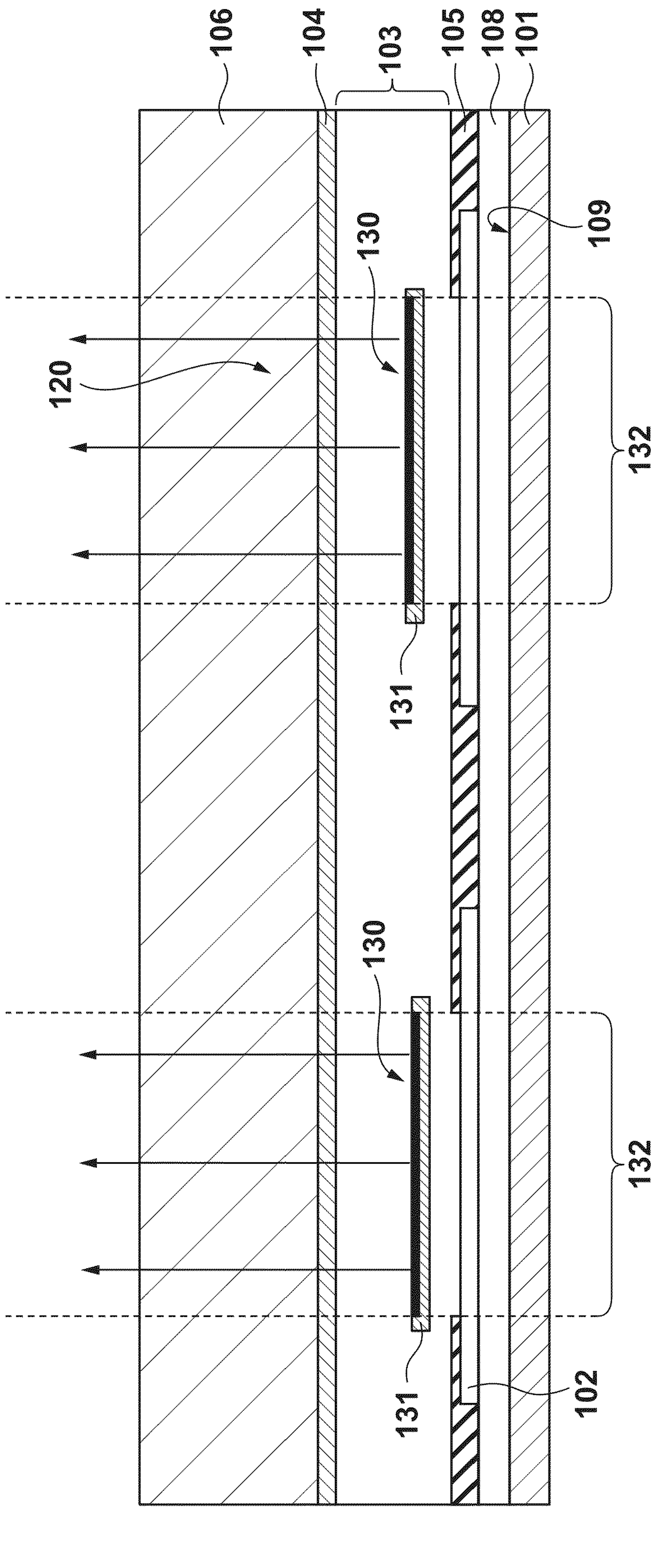


FIG. 8

F I G. 9

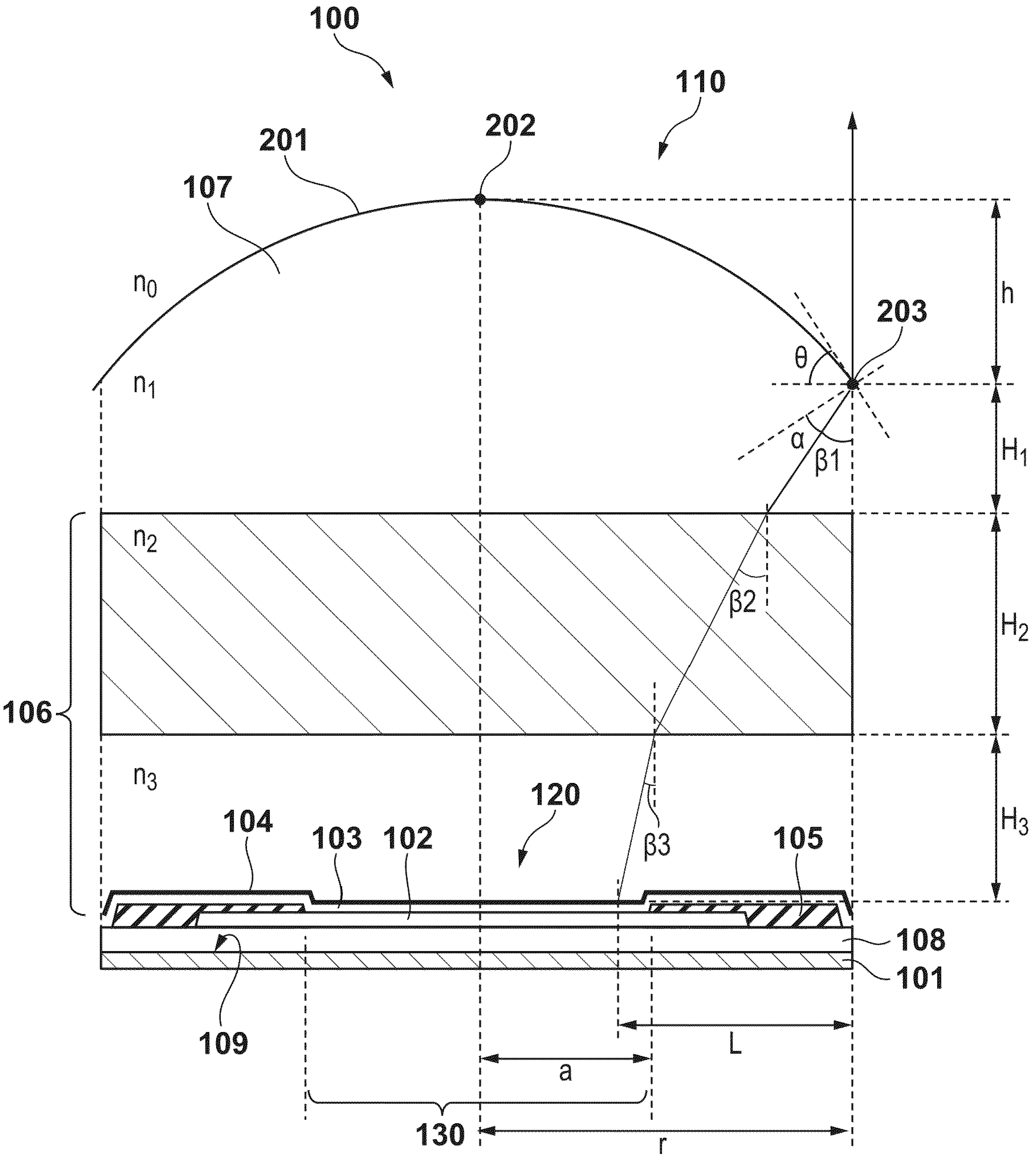
100
110
201
202
107
$n_0$
203
h
θ
$n_1$
α
β1
$H_1$
$n_2$
β2
$H_2$
106
$n_3$
120
β3
$H_3$
104
103
102
105
108
101
109
L
a
130
r

F I G. 10A

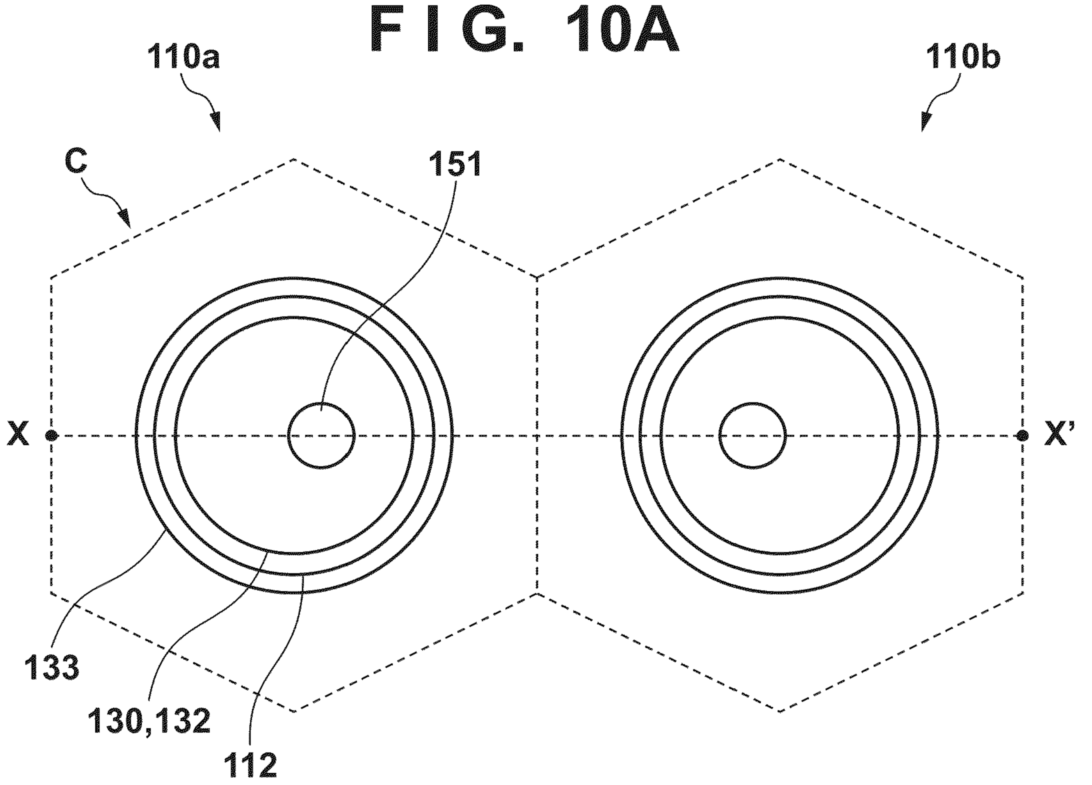


F I G. 10B

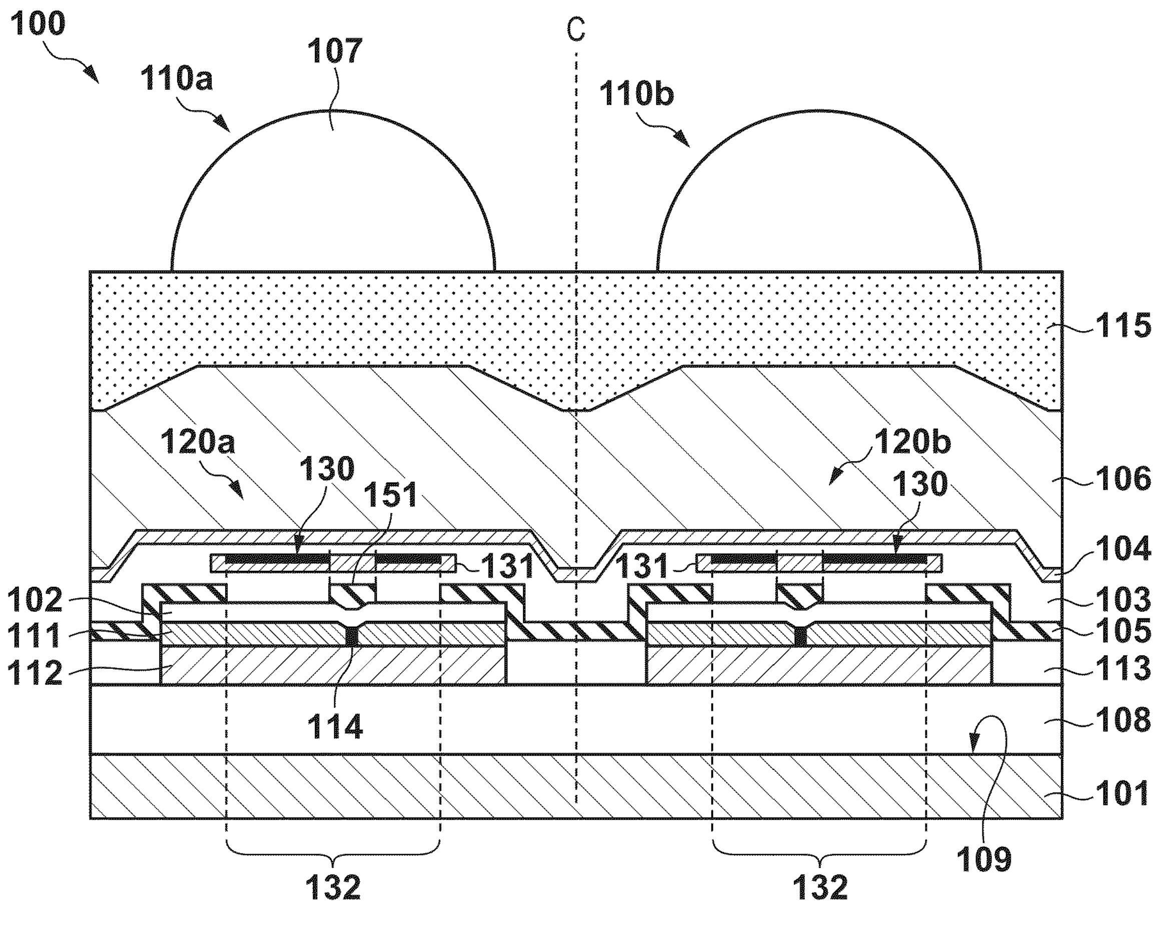

FIG. 11

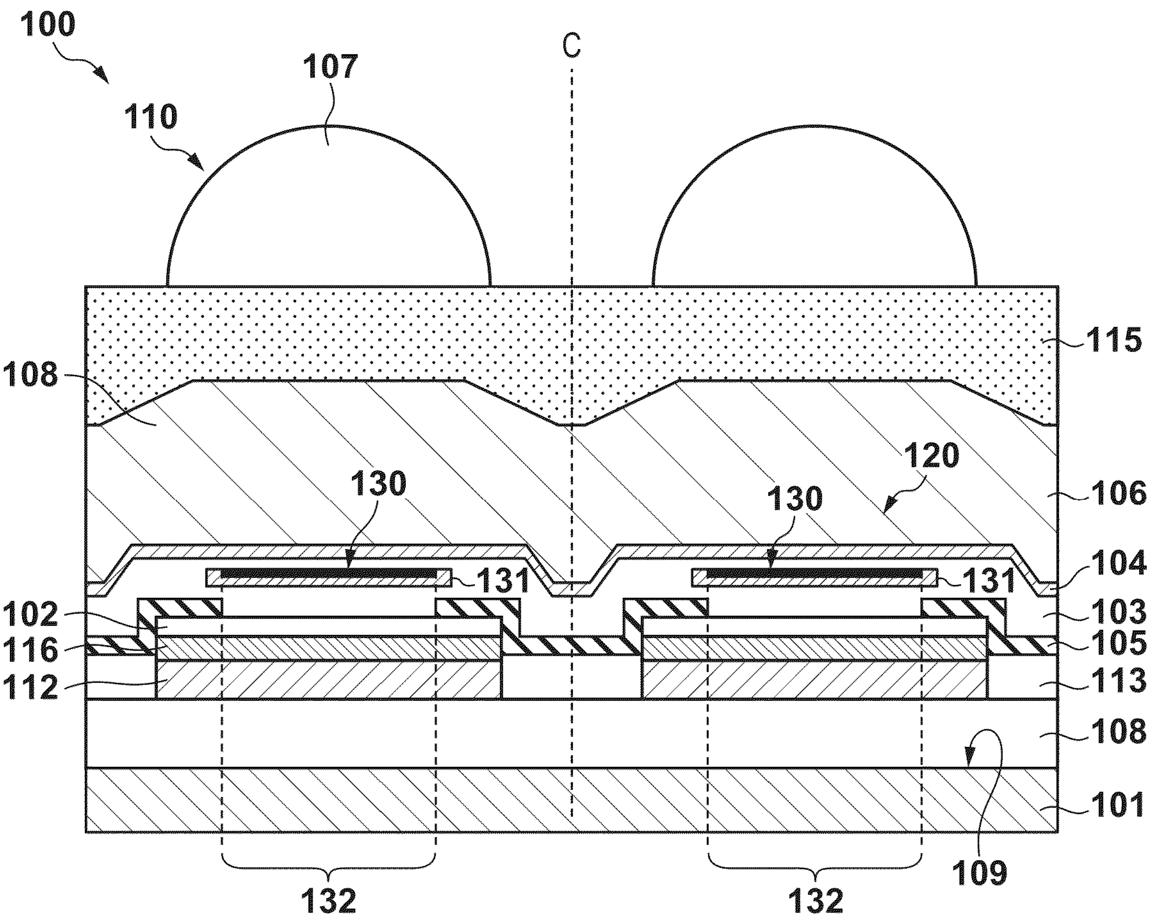
100
107
110
C
115
108
120
106
130
130
131
131
104
102
103
116
105
112
113
108
101
109
132
132

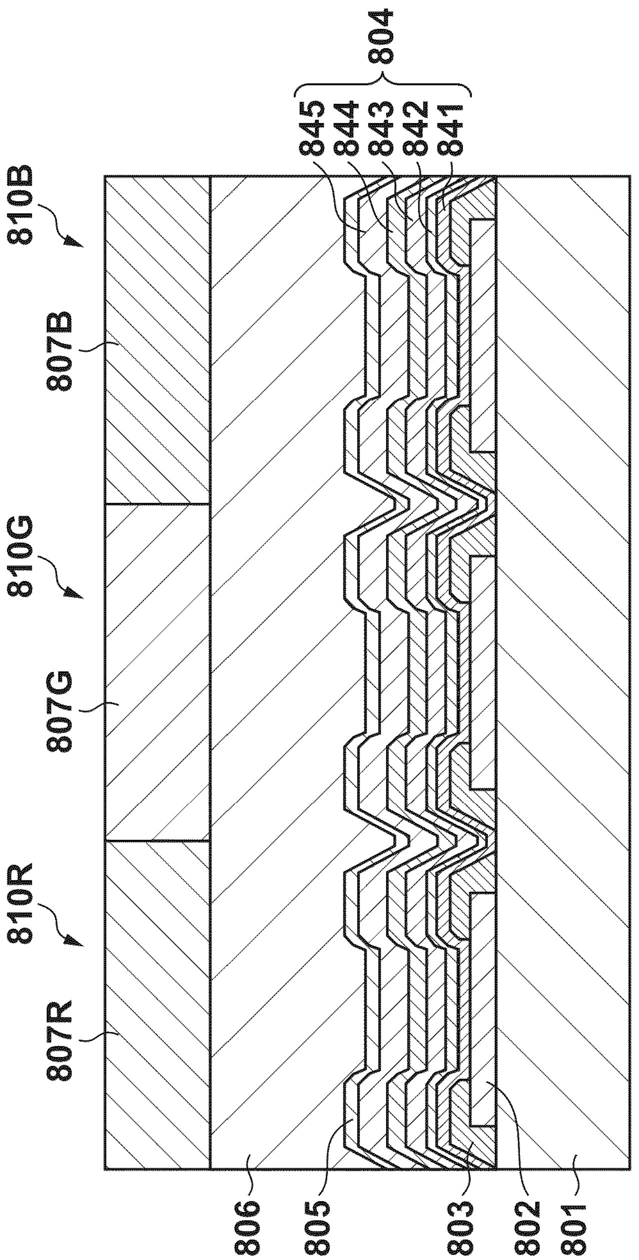


FIG. 12A

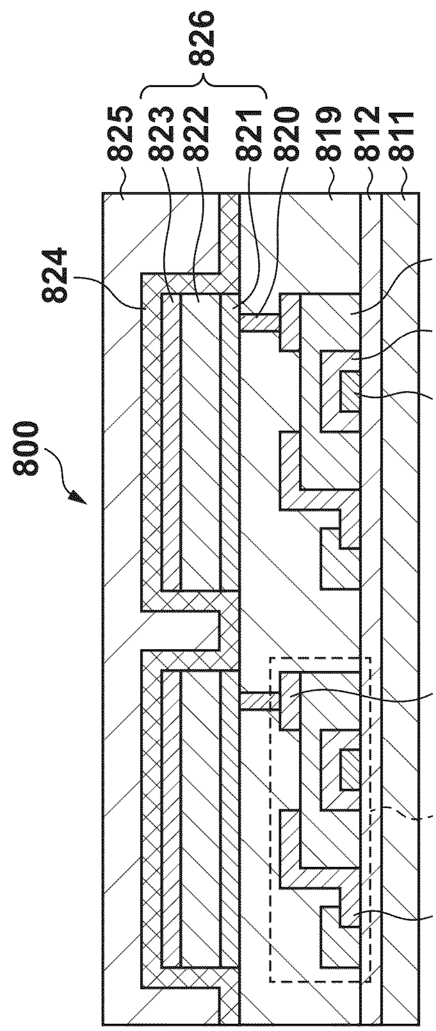


FIG. 12B

FIG. 13A

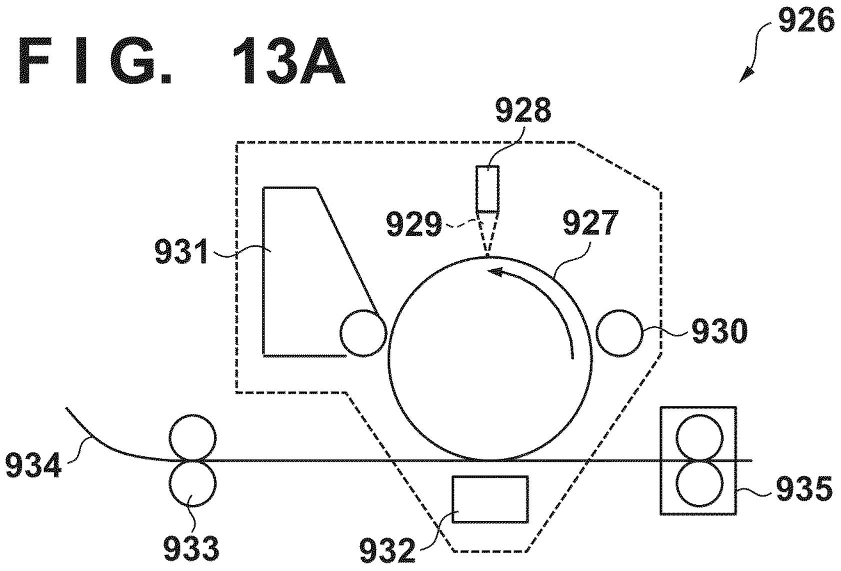


FIG. 13B

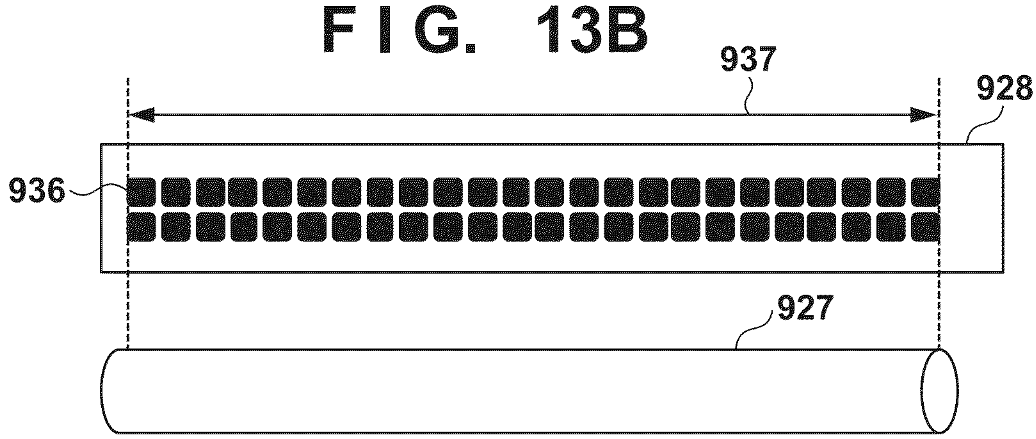


FIG. 13C

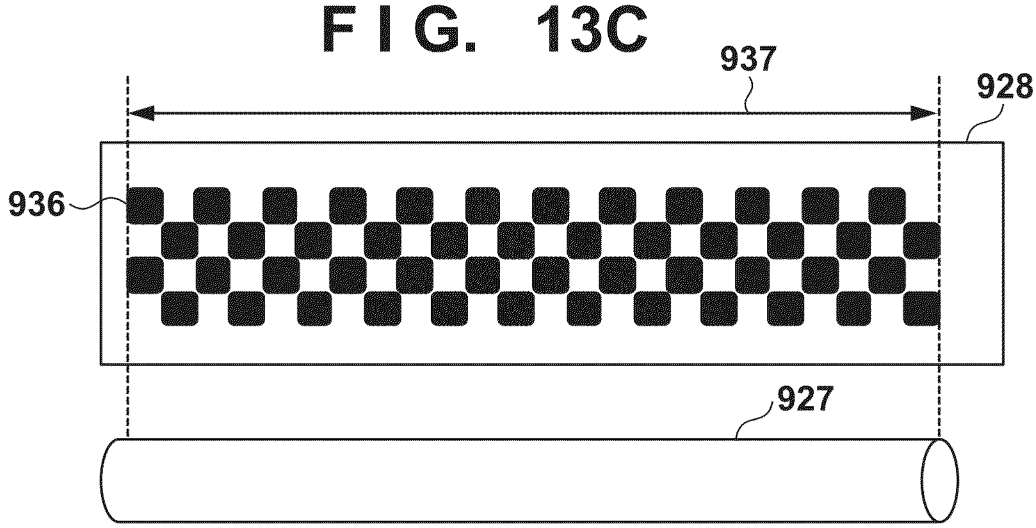

FIG. 14

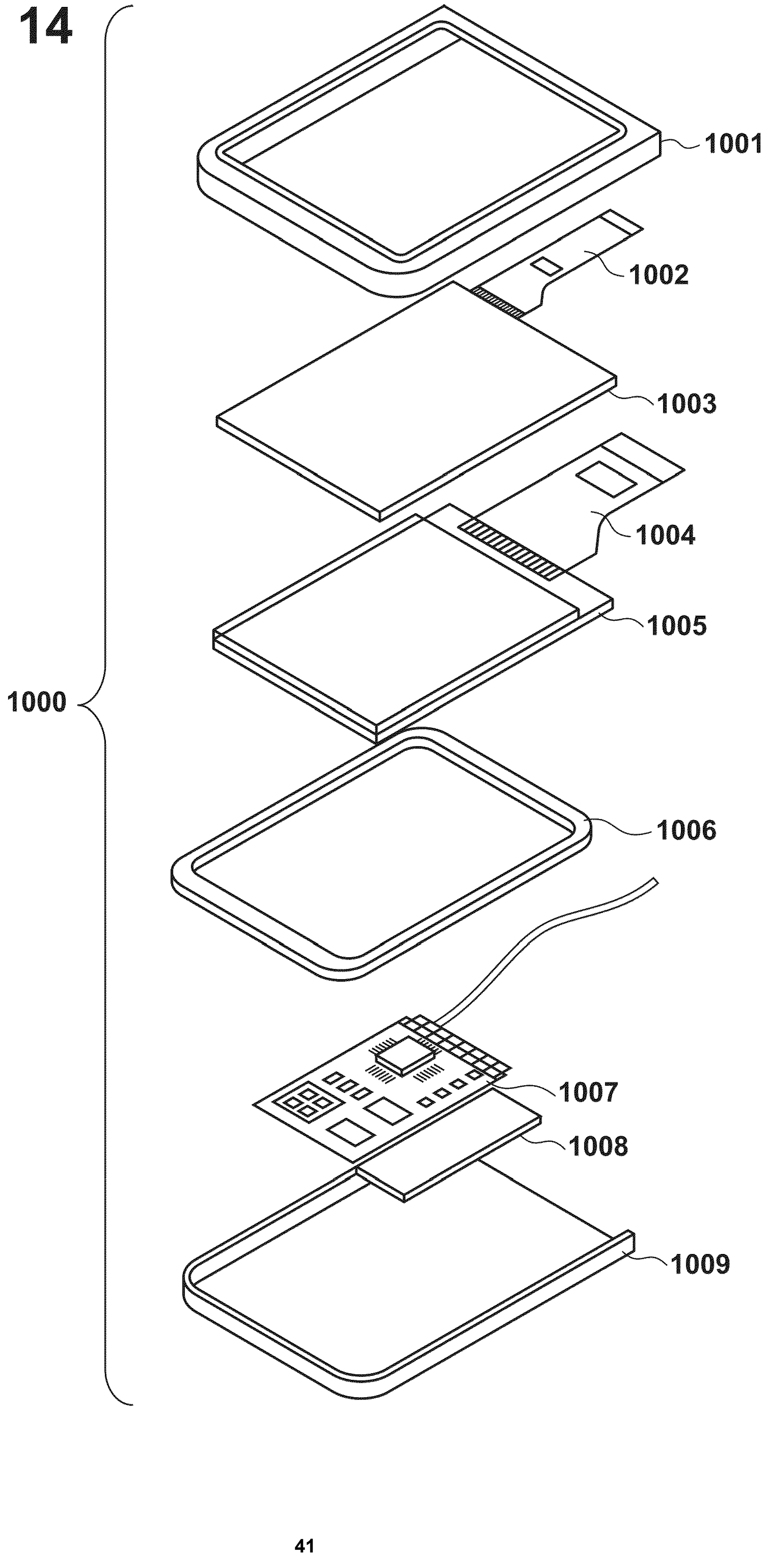

F I G. 15

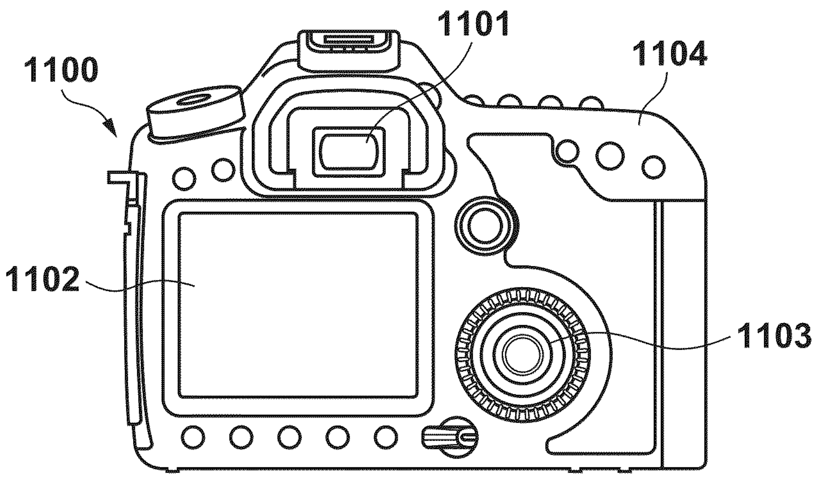


F I G. 16

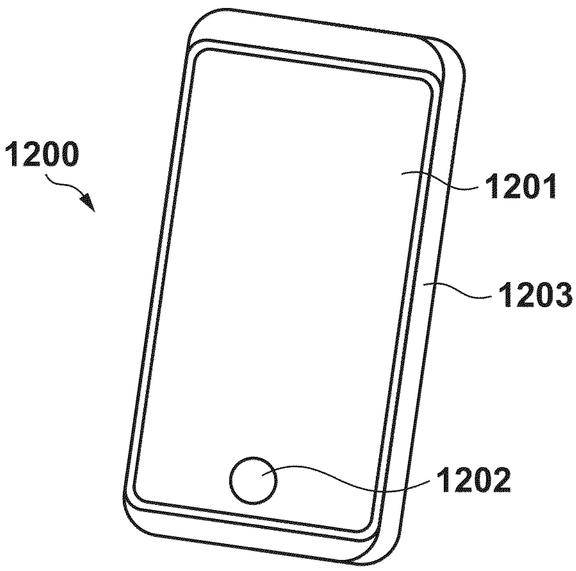

# FIG. 17A

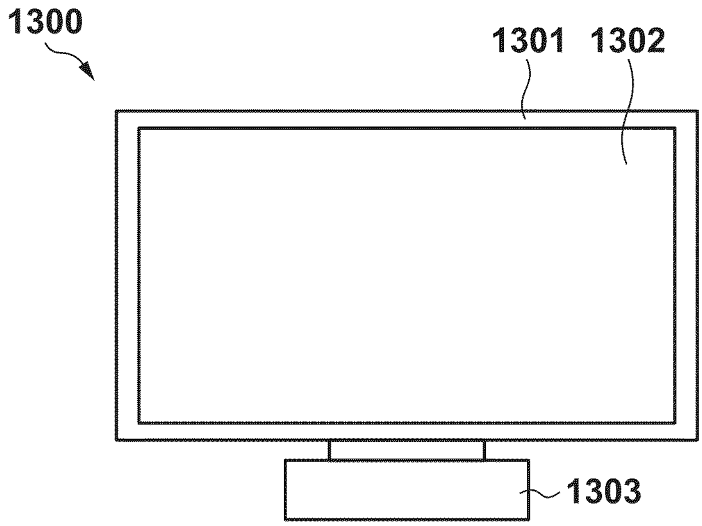


# FIG. 17B

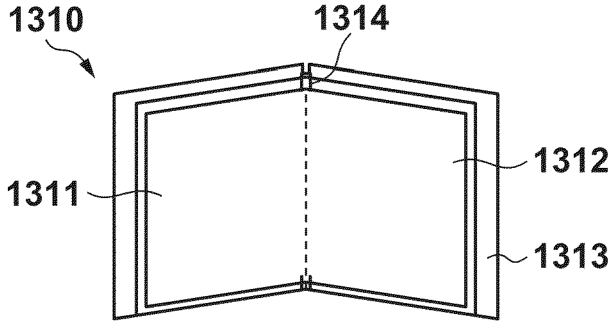

FIG. 18

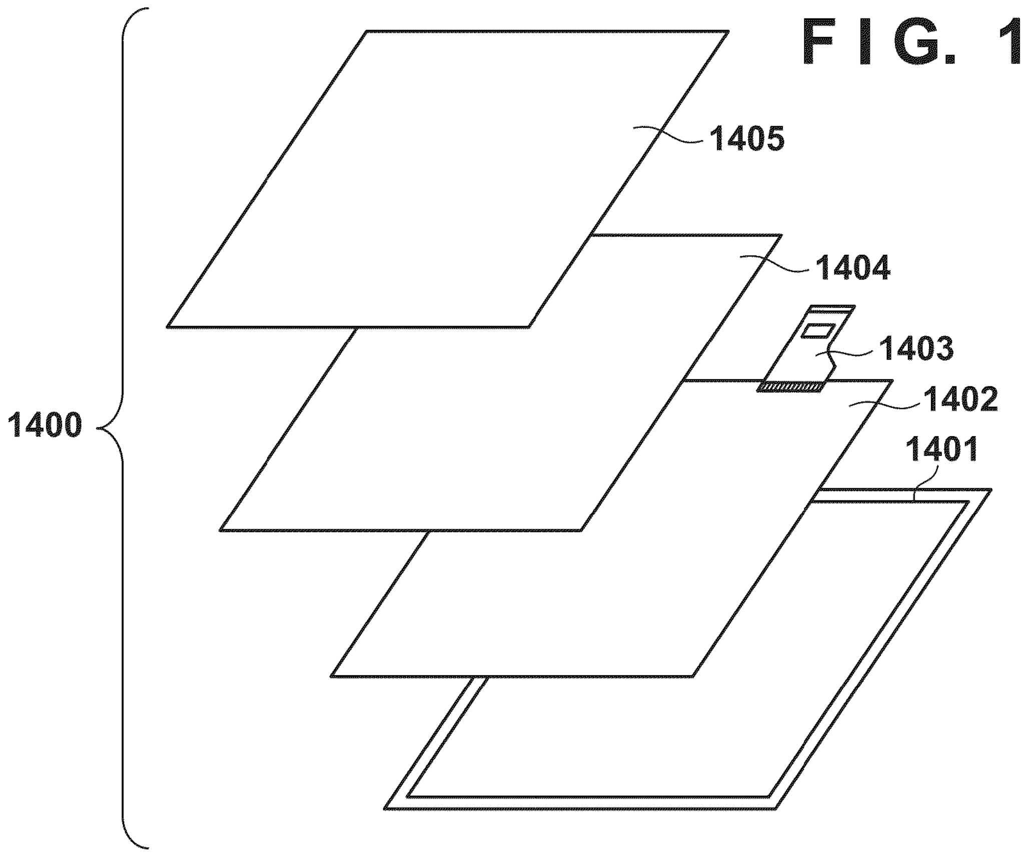

FIG. 19A

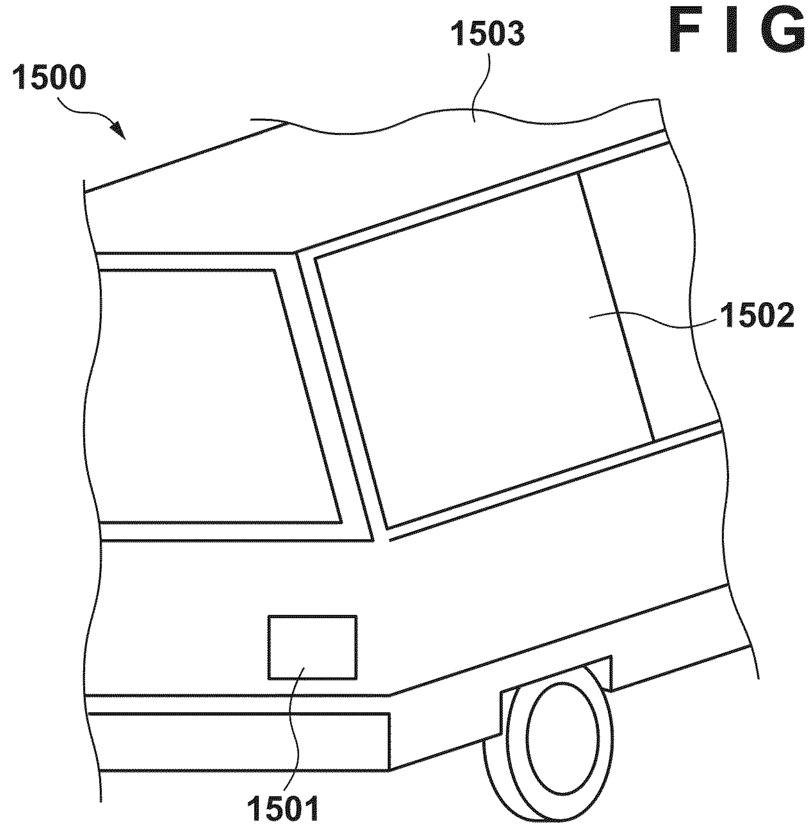


FIG. 19B

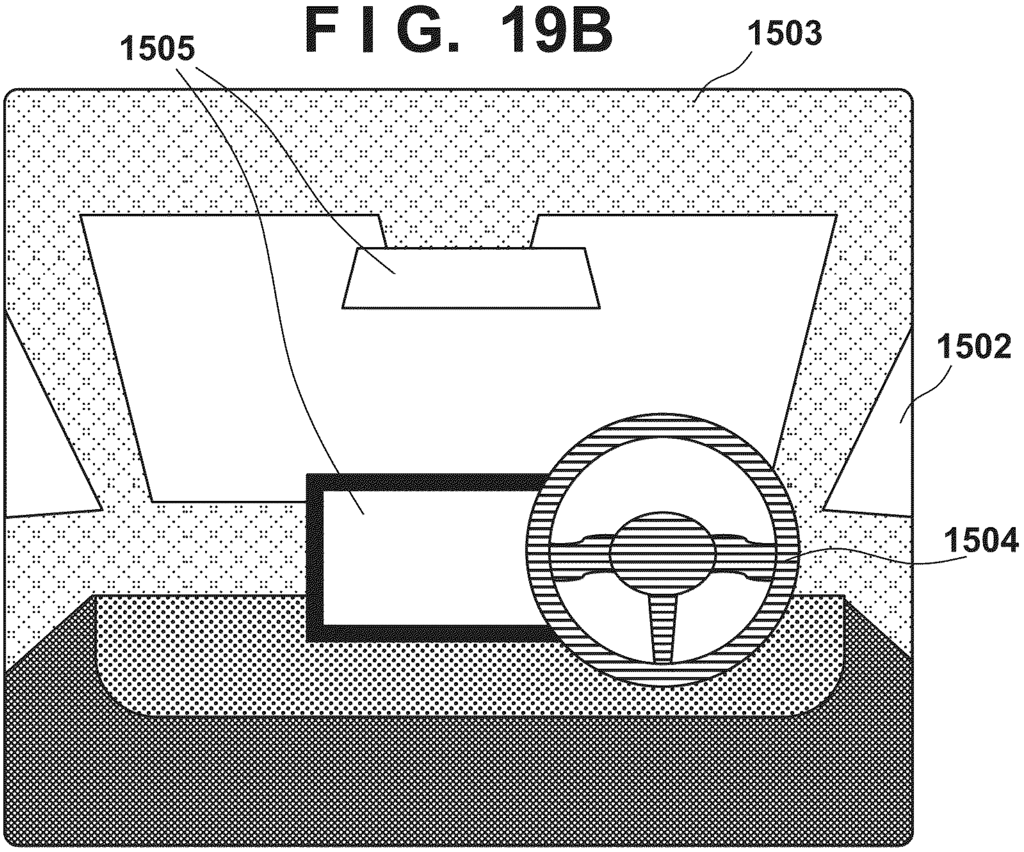

# F I G. 20A

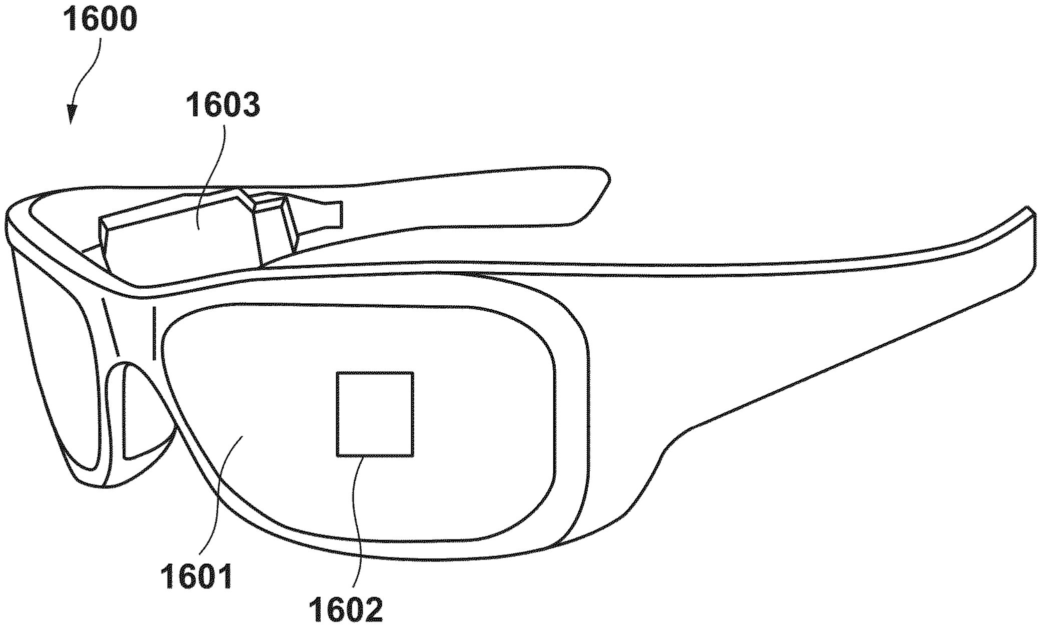


# F I G. 20B

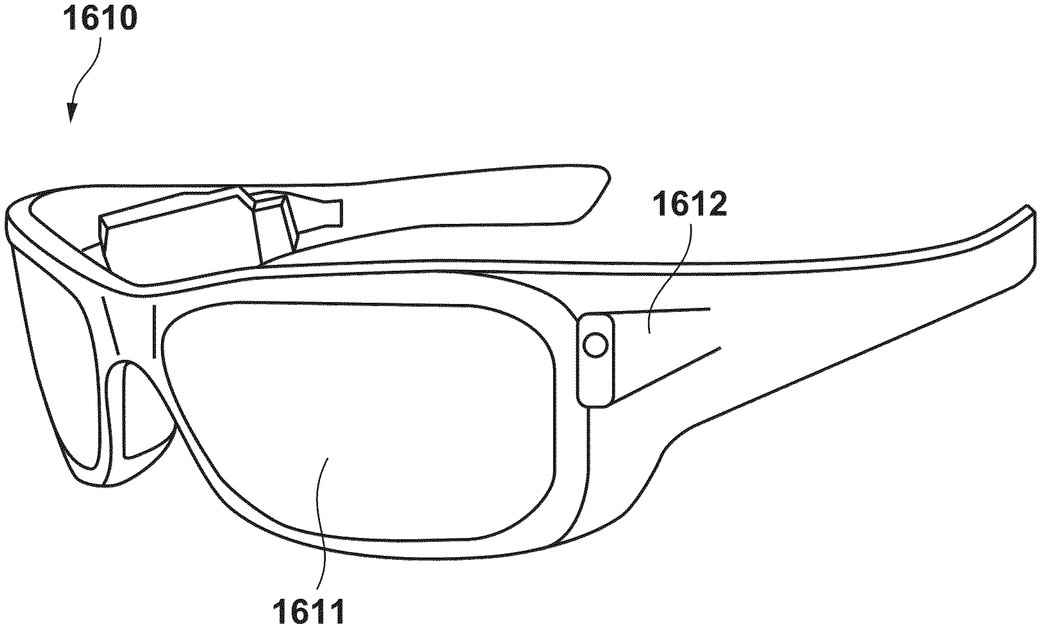

Europäisches Patentamt
European Patent Office
Office européen des brevets

# EUROPEAN SEARCH REPORT

Application Number
EP 25 21 4205

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2024/161978 A1 (CANON KK [JP]) 8 August 2024 (2024-08-08) | 1-3,7-20 | INV. H10K59/121 H10K59/80 |
| Y | * paragraph [0009] - paragraph [0045]; | 1-3,7-20 | |
| A | figures 1,7,8 * | 4-6 | |
| Y | JP 2022 080507 A (SEIKO EPSON CORP) 30 May 2022 (2022-05-30) | 1-3,7-20 | |
| A | * paragraph [0064] - paragraph [0075]; figures 7-10 * | 4-6 | |
| A | US 2023/122008 A1 (FUKUCHI YUSUKE [JP]) 20 April 2023 (2023-04-20) * paragraph [0054] - paragraph [0139]; figures 8-10 * | 1-20 | |

TECHNICAL FIELDS SEARCHED (IPC)

H10K

The present search report has been drawn up for all claims

3

| Place of search | Date of completion of the search | Examiner |
|---|---|---|
| Munich | 6 March 2026 | Bernabé Prieto, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 25 21 4205

This annex lists the patent family members relating to the patent documents cited in the above-mentioned European search report. The members are as contained in the European Patent Office EDP file on
The European Patent Office is in no way liable for these particulars which are merely given for the purpose of information.

06-03-2026

| Patent document cited in search report | Publication date | Patent family member(s) | Publication date |
|---|---|---|---|
| WO 2024161978 A1 | 08-08-2024 | CN 120604653 A | 05-09-2025 |
| | | EP 4648585 A1 | 12-11-2025 |
| | | KR 20250133366 A | 05-09-2025 |
| | | US 2025351712 A1 | 13-11-2025 |
| | | WO 2024161978 A1 | 08-08-2024 |
| JP 2022080507 A | 30-05-2022 | CN 114551524 A | 27-05-2022 |
| | | JP 2022080507 A | 30-05-2022 |
| | | US 2022158135 A1 | 19-05-2022 |
| US 2023122008 A1 | 20-04-2023 | JP 7805125 B2 | 23-01-2026 |
| | | JP 2023056962 A | 20-04-2023 |
| | | US 2023122008 A1 | 20-04-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2022080507 A